# EUROPEAN PATENT SPECIFICATION

(11) **EP 3 495 433 B1**
(45) Date of publication and mention of the grant of the patent: **10.11.2021**
(21) Application number: 18210725.0
(22) Date of filing: 06.12.2018
(51) Int. Cl.: C09D 125/18, C09D 133/14, C09D 179/02, C08G 73/02, G03F 7/09

(54) **CONDUCTIVE POLYMER COMPOSITION, COATED ARTICLE, AND PATTERNING PROCESS**
LEITFÄHIGE POLYMERZUSAMMENSETZUNG, BESCHICHTETER ARTIKEL UND STRUKTURIERUNGSVERFAHREN
COMPOSITION POLYMÈRE CONDUCTRICE, ARTICLE REVÊTU ET PROCÉDÉ DE FORMATION DE MOTIFS

(30) Priority: 07.12.2017 JP 2017235494
(43) Date of publication of application: 12.06.2019
(73) Proprietor: Shin-Etsu Chemical Co., Ltd., Chiyoda-ku, Tokyo (JP)
(72) Inventor: Nagasawa, Takayuki, Niigata (JP)
(74) Representative: Wibbelmann, Jobst

(56) References cited:
- KR-A- 20170 120 940
- US-A1- 2014 038 104
- US-A1- 2016 091 792

## Description

### TECHNICAL FIELD

The present invention relates to a conductive polymer composition containing a polyaniline-based conductive polymer, a coated article using the same, and a patterning process.

### BACKGROUND ART

In the fabrication process of a semiconductor device such as IC and LSI, microprocessing by lithography using a photoresist has been conventionally employed. This is a method of etching a substrate by using a resist pattern as a mask, in which the resist pattern is obtained by irradiating a thin-film with light to induce crosslinking or decomposition reaction, thereby remarkably changing the solubility of the thin-film, and subjecting the same to development treatment with a solvent or the like. In recent years, as a semiconductor device advances toward high integration, high-precision microprocessing using a beam with short wavelength have been required. The development of lithography using electron beam has been progressed for next generation technique because of its short-wavelength properties.

The lithography using electron beam has a specific problem of electrification phenomenon (charge-up) during exposure. This is a phenomenon that when a substrate to be irradiated with electron beam is coated with an insulating resist film, it is charged by accumulation of electric charge on or in the resist film. An orbit of incident electron beam is bent by the electrification, and therefore the precision of drawing is significantly reduced. Accordingly, a peelable antistatic film to be applied on an electron beam resist has been investigated.

In the lithography using an electron beam, accurate positioning has been more important in an electron beam drawing of an electron beam resist due to miniaturization to <10 nm generation. As the drawing technology, it has been developing an enhancement of current in prior arts, MBMW (multi beam mask writing), and so on, and it is presumed that the resist will be electrified more severely thereby. Accordingly, a conductive polymer with lower resistivity and higher ability to release the charge is required as a means to improve the antistatic performance of an antistatic film coping to the development of drawing technology from now on.

In order to suppress lowering of drawing accuracy due to electrification phenomenon on a resist, Patent Document 1 discloses that the resist is coated with a π-conjugated conductive polymer having an introduced acidic substituent in the structure, and thus formed conductive polymer film shows an antistatic effect in electron beam drawing, thereby dissolving various faults due to electrification such as a deformation of a resist pattern or an electrostatic adverse effect to accurate positioning of lithography in an electron beam irradiation. It is also revealed that the conductive polymer film retains water solubility even after electron beam drawing with high irradiation dosage, and accordingly can be removed by water washing.

Patent Document 2 discloses a composition composed of a polyaniline base conductive polymer, polyacid, and H₂O; and reveals that when the composite composed of a polyaniline base conductive polymer and polyacid is 5 to 10% by mass, the spin coat-film forming can be favorably performed, and in addition to this, when the film thickness is 150 nm, antistatic performance is observed, thereby forming an antistatic film which can be peeled and washed with H₂O.

Patent Document 3 discloses a technology used for an antistatic film for electron beam lithography of a polythiophene base conductive polymer, which reveals a composite of a polythiophene base conductive polymer and polyanion having an antistatic film function effected by an addition of gemini surfactant, etc.
US 2014/0038104 A1 discloses compositions comprising polyaniline copolymers and polymeric acids (Example 3 discloses the use of poly(aniline-co-2-fluoroaniline) polymer).

### CITATION LIST

### PATENT LITERATURE

Patent Literature 1: Japanese Patent No. 2902727
Patent Literature 2: US Patent No. 5,370,825
Patent Literature 3: Japanese Patent Laid-Open Publication No. 2014-009342

### SUMMARY OF INVENTION

### TECHNICAL PROBLEM

The antistatic film for electron beam drawing revealed in Patent Document 1 uses a π-conjugated conductive polymer in which an acidic substituent is introduced into monomer unit structures thereof, and forms self-doping of the acidic substituent to the π-conjugated conductive polymer chain. Accordingly, the acidic substituent and the monomer composing the π-conjugated conductive polymer are always contained in a ratio of 1:1, which makes it difficult to alter the doping ratio of the π-conjugated conductive polymer and the acidic substituent in order to adapt to the use and the object. Moreover, it is also difficult to alter the ratio of the non-doping acidic substituent, which largely influences properties such as solubility or dispersity to H₂O, and re-aggregation. Accordingly, there has been a problem such as causing re-aggregation during the storage to make the liquid inhomogeneous and to generate a defect easily in peeling step when applied as an antistatic film onto a resist.

On the whole, polyaniline composites using unsubstituted aniline as the raw material have higher electric conductivity, but show poor hydrophilicity and poor dispersibility to H₂O to cause extremely inferior film formability onto a substrate. On the other hand, in the composition described in Patent Document 2, various substituents are introduced into the aniline skeleton of the composite composed of the polyaniline base conductive polymer to be the base polymer and polyacid, thereby improving the polyaniline composite in dispersibility to H₂O and film formability on a substrate, and showing rapid response in a H₂O-peeling and washing step in the use of an antistatic film for electron beam lithography. The introduction of substituents other than hydrogen atoms into the aniline skeleton, however, makes it difficult to provide higher electric conductivity, that is, makes it difficult to improve lowering of resistivity, which is a property index to show antistatic performance. Accordingly, the composition fails to cope with sufficient release of the electricity to be charged in a prospective drawing process, which will intensely generate the foregoing electrification condition of a resist layer.

The π-conjugated conductive polymers used for antistatic film use in a drawing step of electron beam lithography include polythiophene base conductive polymers except for the polyaniline base conductive polymers. The polythiophene base conductive polymer generally shows higher electric conductivity compared to polyaniline base conductive polymers, but has lower affinity to H₂O compared to polyaniline base conductive polymers. Accordingly, even in the H₂O-dispersed material, the formed film is hardly peeled in peeling and washing step with H₂O, and the peeled film is not fully dissolved or re-dispersed into H₂O if it was peeled, and floats in a solid state such as a flake, and can cause a serious pattern defect in lithography thereby.

Patent Document 3 discloses a technology used for an antistatic film for electron beam lithography of a polythiophene base conductive polymer, which reveals a composite of a polythiophene base conductive polymer and polyanion having an antistatic film function and good peelability to H₂O effected by an addition of gemini surfactant, etc. The composition described in Patent Document 3 comprises a composite of a polythiophene base conductive polymer and polyacid as a base polymer, and accordingly acid due to the polyacid can influence the resist film as the composite composed of the polyaniline base conductive polymer and polyacid described in Patent Document 2. To this problem, Patent Document 3 uses a neutralization agent such as amines to moderate the acidity, thereby keeping the influence on lithography to a minimum. However, when gemini surfactant is added in order to apply functions of good coating property and peelability, and amine is added in order to moderate the acidity, the film shows an equivalent or larger surface resistivity (Ω/□), which is an index of antistatic performance, compared to the polyaniline base antistatic film described in Patent Document 2, which probably fails to exhibit sufficient antistatic performance, and in conclusion, it fails to reveal the low-resistivity function intrinsic to the polythiophene base conductive polymer. Therefore, it is feared to fail to cope with the sufficient release of the charge in a drawing process, requiring high antistatic property in future.

On account of the foregoing, it has been required to develop an antistatic film for electron beam-resist drawing having good filterability and good film-formability onto an electron beam resist to form a flat film, showing excellent antistatic performance even in an electron beam drawing step on the basis of the low surface resistivity (Ω/□), and having good peelability with H₂O or an alkaline developer after the drawing.

The present invention was made in view of the above circumstances, and an object thereof is to provide a conductive polymer composition having good filterability and film-formability of a flat film onto an electron beam resist, and being suitably usable for a antistatic film for electron beam resist drawing having lower surface resistivity (Ω/□) to show excellent antistatic performance in an electron beam drawing process, and excellent peelability with H₂O or an alkaline developer after drawing.

### SOLUTION TO PROBLEM

To solve the above problems, the present invention provides a conductive polymer composition comprising:
(A) a polyaniline-based conductive polymer having two or more kinds of repeating units shown by the following general formula (1); and
(B) a dopant polymer which contains a repeating unit shown by the following general formula (2) and has a weight-average molecular weight in a range of 1,000 to 500, 000;
   wherein the weight-average molecular weight is a measured value in terms of polyethylene oxide, polyethylene glycol, or polystyrene by gel permeation chromatography using water, dimethylformamide, or tetrahydrofuran as a solvent, 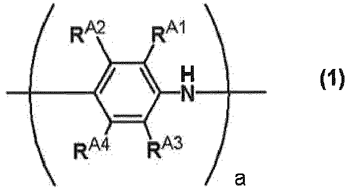 wherein R^{A1} to R^{A4} each independently represent any of a linear, branched, or cyclic monovalent hydrocarbon group having 1 to 20 carbon atoms and optionally containing a heteroatom, a hydrogen atom, and a halogen atom; R^{A1} and R^{A2} or R^{A3} and R^{A4} are optionally bonded to each other to form a ring; and "a" is a molar ratio satisfying 0 < a < 1.0; 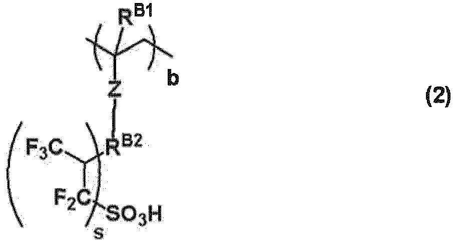 wherein R^{B1} represents a hydrogen atom or a methyl group; R^{B2} represents any of a single bond, an ester group, and a linear, branched, or cyclic hydrocarbon group having 1 to 12 carbon atoms and optionally containing either or both of an ether group and an ester group; "Z" represents any of a single bond, a phenylene group, a naphtylene group, and an ester group; "b" is a molar ratio satisfying 0 < b ≤ 1.0; and "s" is an integer of 1.

The inventive conductive polymer composition has good filterability and film-formability of a flat film onto an electron beam resist, and is suitably usable for a antistatic film for electron beam resist drawing having lower surface resistivity (Ω/□) to show excellent antistatic performance in an electron beam drawing process, and excellent peelability with H₂O or an alkaline developer after drawing.

In the component (A), the repeating units of the component (A) preferably contains a repeating unit-al, in which all of R^{A1} to R^{A4} are hydrogen atoms, in a ratio of 50% < a1 < 100%.

In the component (A), the repeating units of the component (A) preferably contains a repeating unit-al, in which all of R^{A1} to R^{A4} are hydrogen atoms, in a ratio of 80% ≤ a1 < 100%.

With the component (A) like this, the conductive polymer composition has good filterability and film-formability of a flat film onto an electron beam resist, and is suitably usable for a antistatic film for electron beam resist drawing having lower surface resistivity (Ω/□) to show excellent antistatic performance in an electron beam drawing process, and excellent peelability with H₂O or an alkaline developer after drawing.

In this case, it is preferable that the repeating unit-b in the component (B) contains at least one kind of repeating unit selected from the group consisting of repeating units b2 and b4-b8 shown by the following general formulae (2-2) and (2-4) to (2-8); 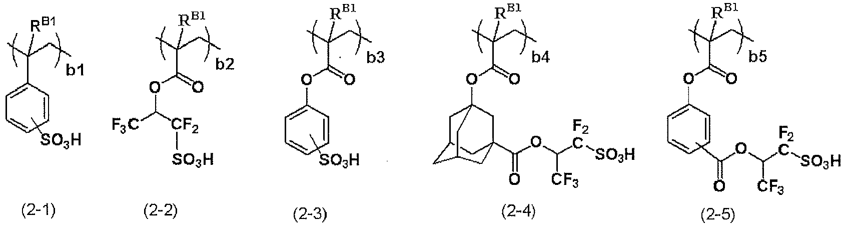 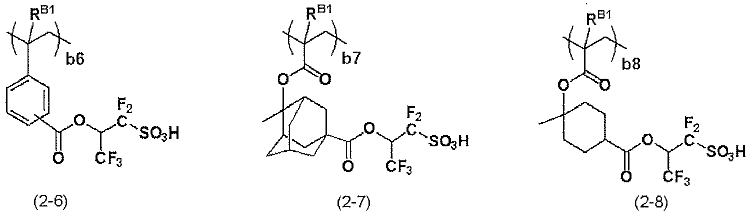 wherein R^{B1} has the same meaning as defined above, and b1, b2, b3, b4, b5, b6, b7, and b8 are numbers each satisfying 0 ≤ b1 ≤ 1.0, 0 ≤ b2 ≤ 1.0, 0 ≤ b3 ≤ 1.0, 0 ≤ b4 ≤ 1.0, 0 ≤ b5 ≤ 1.0, 0 ≤ b6 ≤ 1.0, 0 ≤ b7 ≤ 1.0, 0 ≤ b8 ≤ 1.0, and 0 < b1+b2+b3+b4+b5+b6+b7+b8 ≤ 1.0.

The composition, containing a composite formed from the both components (A) and (B) like these, comes to have good filterability and film-formability of a flat film onto an electron beam resist, and to form a conductive film with excellent electric conductivity, that is, having lower surface resistivity (Ω/□) to show excellent ability to release the charge accumulated on the resist surface during a process of electron beam resist drawing. That is, due to this ability to release the charge, the shift of drawing position caused by charging is corrected. Accordingly, the conductive polymer composition can be suitably used for an antistatic film that provides high positional accuracy in electron beam resist lithography and is excellent in peelability with H₂O or an alkaline developer after film forming.

It is also preferable that the conductive polymer composition further comprise (C) an amphoteric ion compound shown by the following general formula (3); 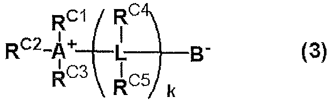 wherein R^{C1} to R^{C3} each independently represent a linear, branched, or cyclic monovalent hydrocarbon group having 1 to 20 carbon atoms and optionally substituted with or containing a heteroatom, or a hydrogen atom; R^{C1} and R^{C2}, or R^{C1}, R^{C2}, and R^{C3} are optionally bonded to each other to form a ring with A⁺ in the formula; A⁺ is a hetero atom and represents a monovalent cation; "k" is an integer of 1 to 8; L represents a carbon atom or a heteroatom, the both of which are optionally contained when "k" is 2 or more; R^{C4} and R^{C5} each represent a hydrogen atom, a hydroxy group, an amino group, or a linear, branched, or cyclic monovalent hydrocarbon group having 1 to 20 carbon atoms and optionally containing a heteroatom; R^{C4} and R^{C5} are optionally bonded to each other to form a ring, and adjoining R^{C4} are optionally bonded to each other to form a ring when "k" is 2 or more; R^{C4} and R^{C5} are optionally bonded to each other with an oxygen atom or a nitrogen atom to form a double bond, and when the double bond is formed with a nitrogen atom, the nitrogen atom is optionally an ion; L is optionally bonded with adjoining A⁺ to form a double bond, and adjoining L optionally form a double bond with each other when "k" is 2 or more; any of R^{C1} to R^{C3} are optionally bonded with R^{C4} or R^{C5} to form a ring; B⁻ is a monovalent anionic functional group and represents a carboxylate ion or a sulfonate ion.

Using the conductive polymer composition that contains the compound shown by the general formula (3) in forming an antistatic film on a body to be processed, it is possible to decrease diffusion of acid between the body to be processed and the antistatic film to reduce an influence due to the acid. The conductive polymer composition like this is excellent in antistatic performance and coating property without badly affecting a resist, and can be favorably used for lithography using electron beam and so on thereby.

In this case, it is further preferable that the component (C) be shown by the following general formula (4); 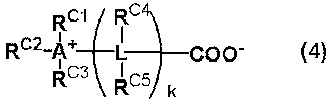 wherein R^{C1} to R^{C5}, A⁺, L, and "k" have the same meanings as defined above.

With containing the amphoteric ion compound shown by the general formula (4) as the component (C), it is possible to moderate the acidity of a composite composed of the component (A) and the component (B), thereby being able to control the acidity by which the acid does not influence on the adjoined layer.

In this case, it is also preferable that the component (C) be in an amount of 1 to 70 parts by mass based on 100 parts by mass of a composite of the component (A) and the component (B).

When the component (C) is in such an amount, it is possible to reduce acid diffusion from the conductive film formed by the conductive polymer composition to the adjoined layer to be contact with. When such a conductive film is formed onto a body to be processed which is a substrate with a chemically amplified resist film, and is intended for an antistatic effect in electron beam drawing, the antistatic effect is achieved, the accuracy of drawing position is improved, and when diffusion of acid from the conductive film strongly influences to a resist, the influence is reduced, thereby making it possible to obtain a high-resolution resist pattern.

It is preferred that the conductive polymer composition further comprise a nonionic surfactant.

Such a conductive polymer composition improves the wettability to a body to be processed such as a substrate.

The nonionic surfactant is preferably in an amount of 1 to 50 parts by mass based on 100 parts by mass of a composite of the component (A) and the component (B).

Such a conductive polymer composition makes the wettability to the surface of a body to be processed more suitable, and give the conductive film sufficient electric conductivity.

The conductive polymer composition is preferably a material for forming a laminated film as a device constituent component in an organic thin-film device.

The conductive polymer composition is preferably a material for forming an electrode film or a material for forming a carrier transferring film.

As described above, the inventive conductive polymer composition has good filterability and can be applied onto any of bodies to be processed to form a film. Accordingly, it is suitable for a material for forming a laminated film as a device constituent component in an organic thin-film device, particularly a material for forming an electrode film or a material for forming a carrier transferring film, other than the use of an antistatic film, and it can be used for forming a homogeneous thin-film with high flatness.

The present invention also provides a coated article, comprising a film formed from the foregoing conductive polymer composition on a body to be processed.

The body to be processed can be a substrate having a chemically amplified resist film.

The body to be processed can be a substrate for obtaining a resist pattern by pattern irradiation with electron beam.

The inventive conductive polymer composition can be suitably used for a lithography particularly by use of electron beam, etc. Accordingly, it is possible to obtain a resist pattern with high sensitivity, high resolution, and a good pattern profile.

The present invention further provides a patterning process comprising the steps of:
forming an antistatic film on a chemically amplified resist film of a substrate having the chemically amplified resist film by using the foregoing conductive polymer composition;
irradiating in a pattern with electron beam; and
developing with an alkaline developer to obtain a resist pattern.

Such a patterning process can avoid an electron beam distortion phenomenon due to charge of the surface of a resist during electron beam drawing, and can give a resist pattern with high sensitivity and high resolution as well as good pattern profile.

### ADVANTAGEOUS EFFECTS OF INVENTION

The inventive conductive polymer composition, containing a composite formed from (A) a polyaniline-based conductive polymer having two or more kinds of repeating units shown by the general formula (1) and (B) a dopant polymer having a sulfo group, can be favorably applied to an antistatic film that shows highly efficient release of charge in charged state during electron beam resist drawing to improve the positional accuracy in electron beam drawing.

The composition that contains the composite of the component (A) having two or more kinds of repeating units and the component (B) exhibits higher electric conductivity, together with higher hydrophilicity and dispersibility to H₂O, good filterability, and film-formability of a flat film onto an electron beam resist; and is easily peeled with H₂O or an aqueous alkaline solution in a peeling process after film forming. The composition that contains the composite of the component (A) having two or more kinds of repeating units and the component (B) like this, having good film-formability and peelability with H₂O or an aqueous alkaline solution, successfully forms a conductive film that exhibits lower surface resistivity (Ω/□), that is, higher electric conductivity, to give high positional accuracy in electron beam drawing to a resist, a favorable resist pattern profile, and an antistatic film that does not form peeled flakes or remained insoluble films on the resist pattern after developing a resist, and is favorably usable for electron beam lithography.

Additionally, when the acidity of the composition is moderated with the component (C), it is possible to control the influence of acid diffusion to the adjoined layer, and to form a conductive film with favorable film quality that has higher electric conductivity and exhibits antistatic performance with higher ability to release the charge.

Moreover, in the inventive composition containing a composite of the component (A) and the component (B), the component (C) does not hinder the peelability by H₂O or an aqueous alkaline solution after the film-forming. The formed film is easily peeled by H₂O or an aqueous alkaline solution, can be peeled by H₂O before a heat treatment after electron beam drawing, can also be peeled by an aqueous alkaline solution (an alkaline developer) as an elution part of a resist pattern in a developing step of a resist pattern in a lithography after a heat treatment subsequent to an electron beam drawing. Such easy film-peeling by H₂O or an aqueous alkaline solution gives an effect of decreasing extremely minute defects due to film-forming material in a peeling step after electron beam drawing.

In addition, coated articles with higher quality can be obtained by coating various bodies to be processed with an antistatic film formed by using the inventive conductive polymer composition.

### DESCRIPTION OF EMBODIMENTS

As described above, it has been required for a conductive polymer composition having good filterability, good coating property and film-formability onto a substrate to form a conductive film with good film quality, and good peelability with H₂O or an aqueous alkaline solution; and forming a conductive film which reveals antistatic performance with high ability to release the charge and does not affect an influence of acid on the adjoined layer to be contact with; thereby being suitably usable for an antistatic film with higher electric conductivity in resist lithography using electron-beam and so on.

Hereinafter, the embodiments of the present invention will be specifically described, but the present invention is not limited thereto.

In the polyaniline composite using only unsubstituted aniline as a material for the component (A), showing higher electric conductivity, the hydrophilicity and dispersibility to H₂O are low. Accordingly, it has been difficult to purify the composite through filtration and to form a flat film on an electron beam resist. It has also been difficult to peel the formed film with H₂O or an aqueous alkaline solution in a peeling process after film forming.

The present inventors have intensively investigated to solve the above-described problems, and consequently found that good filterability and film-formability are possessed by the dispersion of a composite of the component (A) a polyaniline-based conductive polymer having two or more kinds of repeating units, together with the component (B) a polymer which is a polysulfonic acid functioning as a dopant for a conductive polymer material, and has a repeating unit containing a super-acidic sulfo group having a sulfo group in which the α-position is fluorinated; and the conductive polymer composition forms a film which shows good flatness and low surface resistivity (Ω/□), that is, higher electric conductivity, as well as good peelability with H₂O or an aqueous alkaline solution.

The present inventors have also found that the dispersion of the conductive polymer is allowed to moderate the acidity of the dispersion of a composite composed of the component (A) and the component (B) by adding the component (C) an amphoteric ion compound, and allowed to be applied and to be formed to a film while reducing an influence of the acid to the adjoining layer that is in contact with the film; thereby brought the present invention to completion.

It is possible to obtain the inventive conductive polymer composition, which is suitably used for the foregoing uses, by mixing the composite formed from a polyaniline-based polymer of the component (A) and a dopant polymer of the component (B) that contains strong acid or super-acidic sulfo group with a solvent, and additionally with an amphoteric ion compound of the component (C), water-soluble polymer, surfactant, and so on if needed, followed by filtration thereof with a filter, etc., for example. It is possible to obtain a coated article and a substrate having a thin-film formed from the inventive conductive polymer composition by applying the inventive conductive polymer composition onto a substrate, heat treatment, irradiating with IR or UV, etc, for example.

That is, the present invention is a conductive polymer composition comprising:
(A) a polyaniline-based conductive polymer having two or more kinds of repeating units shown by the following general formula (1); and
(B) a dopant polymer which contains a repeating unit shown by the following general formula (2) and has a weight-average molecular weight in a range of 1,000 to 500,000; 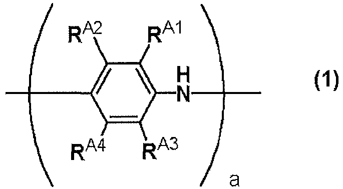 wherein R^{A1} to R^{A4} each independently represent any of a linear, branched, or cyclic monovalent hydrocarbon group having 1 to 20 carbon atoms and optionally containing a heteroatom, a hydrogen atom, and a halogen atom; R^{A1} and R^{A2} or R^{A3} and R^{A4} are optionally bonded to each other to form a ring; and "a" is a number satisfying 0 < a < 1.0; 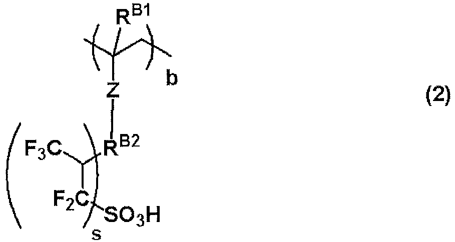 wherein R^{B1} represents a hydrogen atom or a methyl group; R^{B2} represents any of a single bond, an ester group, and a linear, branched, or cyclic hydrocarbon group having 1 to 12 carbon atoms and optionally containing either or both of an ether group and an ester group; "Z" represents any of a single bond, a phenylene group, a naphtylene group, and an ester group; "b" is a number satisfying 0 < b ≤ 1.0; and "s" is an integer of 1.

Hereinafter, the present invention will be described specifically, but the present invention is not limited thereto.

### <Conductive Polymer Composition>

### [(A) polyaniline-based conductive polymer]

The inventive conductive polymer composition contains a polyaniline-based conductive polymer (A) which has two or more kinds of repeating units shown by the following general formula (1).

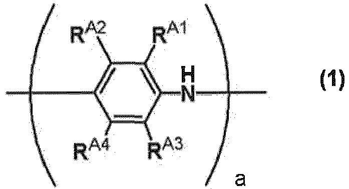

In the formula, R^{A1} to R^{A4} each independently represent any of a linear, branched, or cyclic monovalent hydrocarbon group having 1 to 20 carbon atoms and optionally containing a heteroatom, a hydrogen atom, and a halogen atom; R^{A1} and R^{A2} or R^{A3} and R^{A4} are optionally bonded to each other to form a ring; and "a" is a number satisfying 0 < a < 1.0.

The polyaniline-based conductive polymer is an organic polymer in which the main chain is composed of aniline or an aniline derivative(s) other than parasubstituted derivative thereof. The polymers having similar functions include polypyrroles, polythiophenes, polyacetylenes, polyphenylenes, polyphenylenevinylenes, polyacenes, polythiophenevinylenes, and copolymers thereof. However, the polyaniline-based conductive polymer is selected as the component (A) in view of higher dispersibility to H₂O, filtrability of the dispersion, peelability with H₂O or an alkaline developer after forming a film, low defectiveness in lithography, easiness in polymerization, low re-cohesiveness in storing, and stability in the air.

In the polyaniline-based conductive polymer formed from unsubstituted aniline only, highest electric conductivity can be obtained, but the dispersibility is poor due to the lower affinity to H₂O, and the filtration is difficult and the film formability of the composition is unfavorable. For the same reason, the polymer tends to cause re-cohesion even when it was once dispersed and is inferior in peelability with H₂O or an alkaline developer after forming a film. For these reasons, it is desirable to introduce an aniline monomer having a substituent(s) as a part of the aniline monomers to form the polyaniline-based conductive polymer in order to attain higher dispersibility, low re-cohesiveness, and filtrability of the dispersion; to improve the peelability with H₂O or an alkaline developer after forming a film; and to decrease defects in lithography. Illustrative examples of the substituent introduced thereto include halogen atoms and functional groups, such as alkyl groups, carboxy groups, alkoxy groups, a hydroxy group, and a cyano group.

Illustrative examples of the aniline monomer used to obtain a polyaniline-based conductive polymer with higher affinity to H₂O include aniline, 2-methylaniline, 3-methylaniline, 2-ethylaniline, 3-ethylaniline, 2-isopropylaniline, 2-tert-butylaniline, 2-n-butylaniline, 2,3-dimethylaniline, 2,5-dimethylaniline, 2,6-dimethylaniline, 3,5-dimethylaniline, 2,6-diethylaniline, 2,6-diisopropylaniline, 2,3,5,6-tetramethylaniline, 2-methoxyaniline, 2-isopropoxyaniline, 3-methoxyaniline, 2-ethoxyaniline, 3-ethoxyaniline, 3-isopropoxyaniline, 3-hydroxyaniline, 2,5-dimethoxyaniline, 2,6-dimethoxyaniline, 3,5-dimethoxyaniline, 2,5-diethoxyaniline, 2-methoxy-5-methylaniline, 5-tert-butyl-2-methoxyaniline, 2-chloro-5-methylaniline, 2-chloro-6-methylaniline, 3-chloro-2-methylaniline, and 5-chloro-2-methylaniline. The anilines including these are used as a mixture of two or more kinds thereof in the present invention.

Among them, it is favorable to use a copolymer of unsubstituted aniline and one kind of aniline selected from 2-methylaniline, 3-methylaniline, 2-ethylaniline, 3-ethylaniline, 2-isopropylaniline, 2-methoxyaniline, 3-methoxyaniline, 2-ethoxyaniline, 3-ethoxyaniline, 2-isopropoxyaniline, 3-isopropoxyaniline, and 3-hydroxyaniline in view of dispersibility in H₂O, electric conductivity, reactivity, and thermal stability of the product when the composite is formed with polyanion.

In the component (A), it is also preferable that the repeating units of the component (A) contain a repeating unit-al, in which all of R^{A1} to R^{A4} are hydrogen atoms, in a ratio of 50% < a1 < 100%, more preferably in a ratio of 80% ≤ a1 < 100%.

### [(B) Dopant polymer]

The inventive conductive polymer composition contains a dopant polymer to be a polyanion as the component (B). This dopant polymer of the component (B) contains a repeating unit-b shown by the following general formula (2) and has a weight-average molecular weight in a range of 1,000 to 500,000; 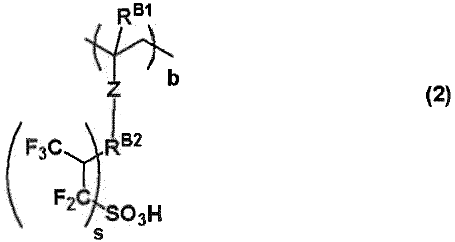 wherein R^{B1} represents a hydrogen atom or a methyl group; R^{B2} represents any of a single bond, an ester group, and a linear, branched, or cyclic hydrocarbon group having 1 to 12 carbon atoms and optionally containing either or both of an ether group and an ester group; "Z" represents any of a single bond, a phenylene group, a naphtylene group, and an ester group; "b" is a number satisfying 0 < b ≤ 1.0; and "s" is an integer of 1.

In this case, it is preferable that the repeating unit-b in the component (B) contain at least one kind of repeating unit selected from the repeating units b2 and b4 to b8 shown by the following general formulae (2-2) and (2-4) to (2-8); 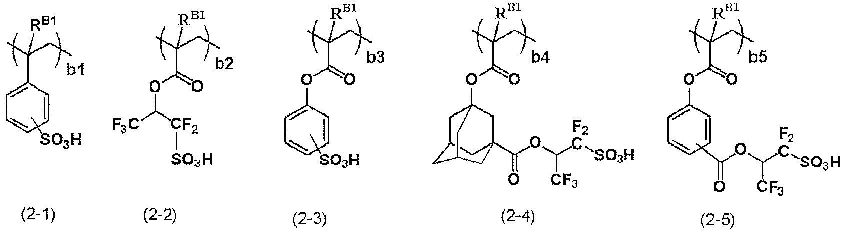 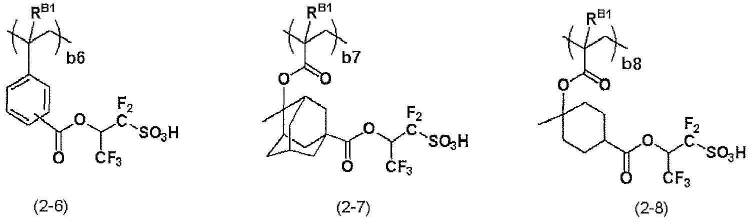 wherein R^{B1} has the same meaning as defined above, and b1, b2, b3, b4, b5, b6, b7, and b8 are numbers each satisfying 0 ≤ b1 ≤ 1.0, 0 ≤ b2 ≤ 1.0, 0 ≤ b3 ≤ 1.0, 0 ≤ b4 ≤ 1.0, 0 ≤ b5 ≤ 1.0, 0 ≤ b6 ≤ 1.0, 0 ≤ b7 ≤ 1.0, 0 ≤ b8 ≤ 1.0, and 0 < b1+b2+b3+b4+b5+b6+b7+b8 ≤ 1.0.

Illustrative examples of the monomer to give the repeating unit "b" include the following. 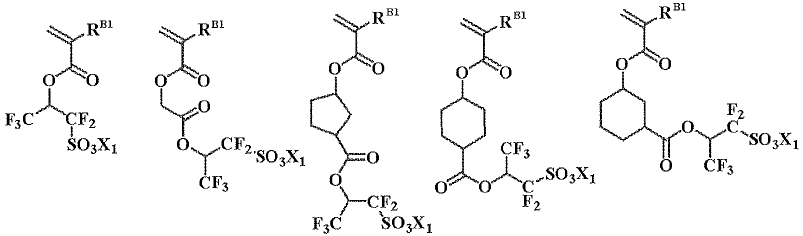 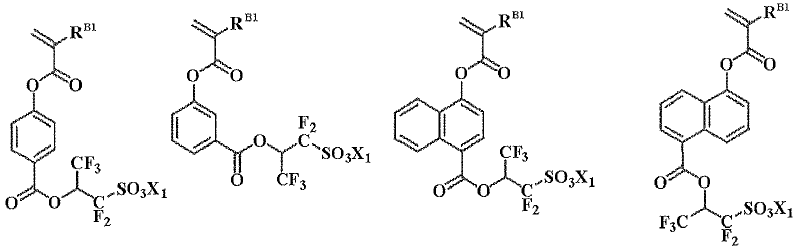 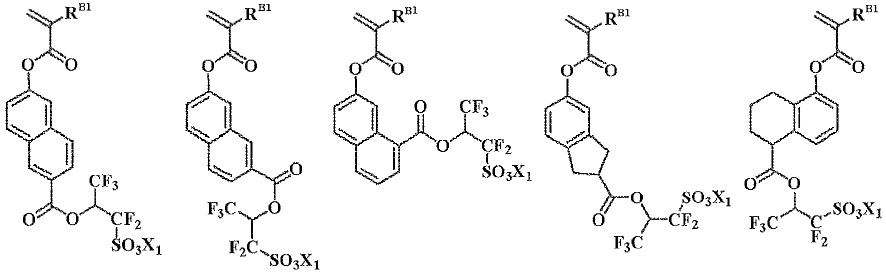 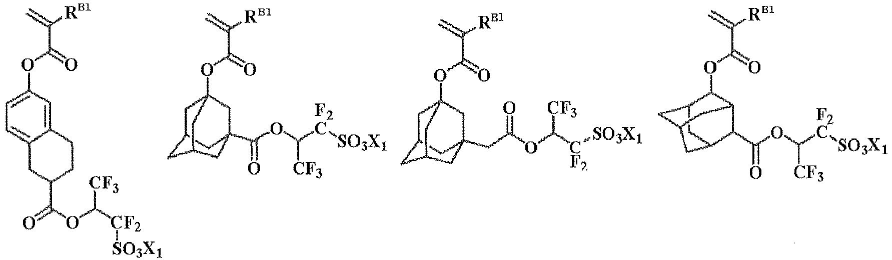 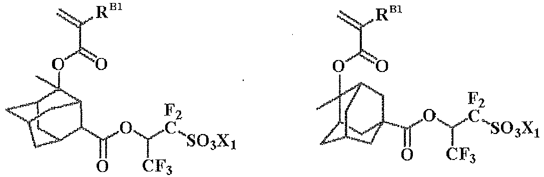 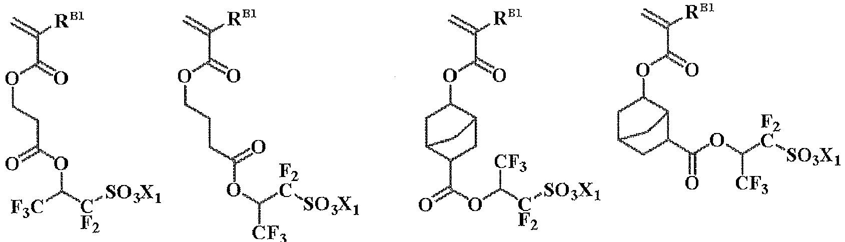 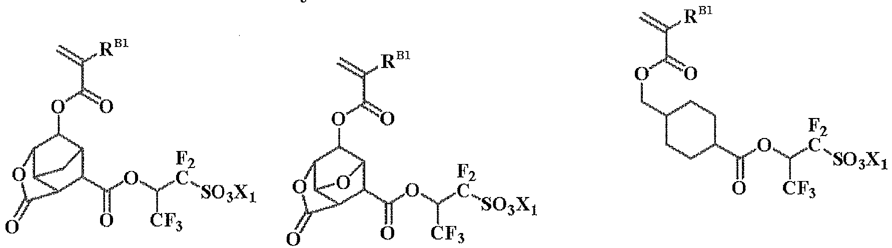 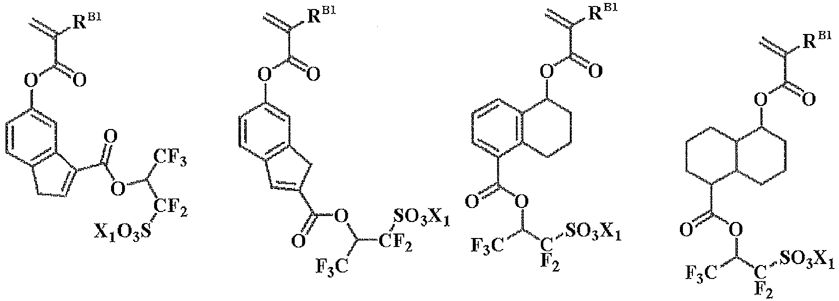 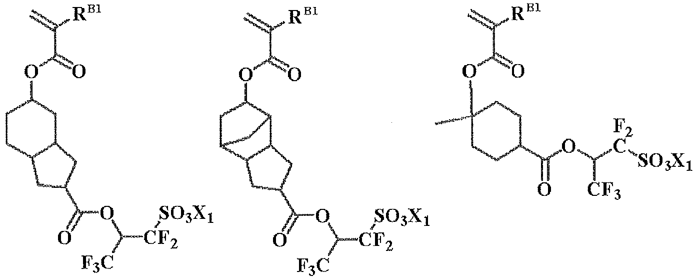 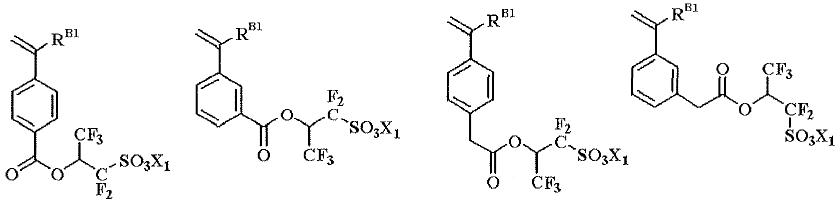 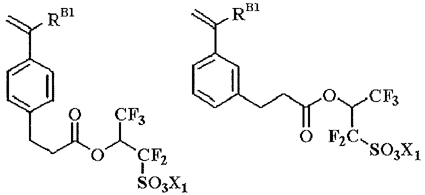 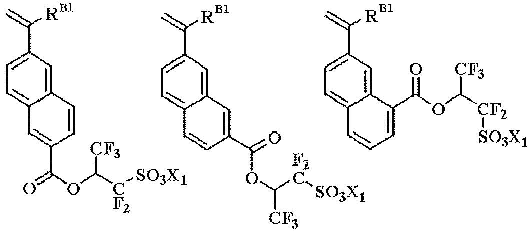 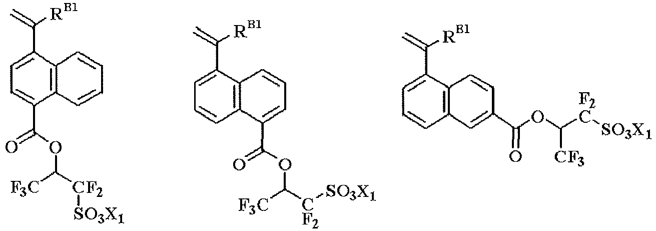 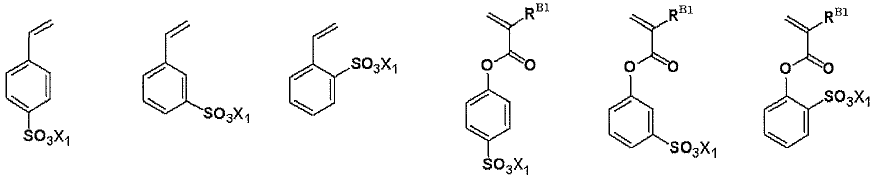 In the formulae, R^{B1} has the same meaning as defined above, and X₁ represents a hydrogen atom, a lithium atom, a sodium atom, a potassium atom, an amine, a sulfonium, or an iodonium.

When X₁ is an amine, illustrative examples thereof include chemical species of (P1a-3) described in paragraph [0048] of Japanese Patent Laid-Open Publication No. 2013-228447.

The dopant polymer of the component (B) can contain a repeating unit-c other than the repeating unit-b, and illustrative examples of this repeating unit-c include styrenes, vinylnaphthalenes, vinylsilanes, acenaphthylene, indene, vinylcarbazole.

Illustrative examples of a monomer to give the repeating unit-c include the following.

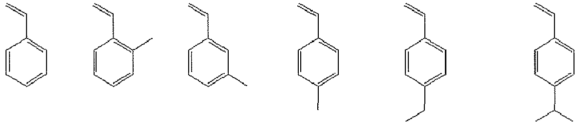

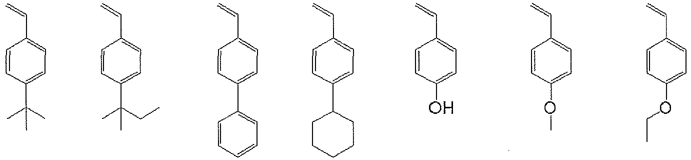

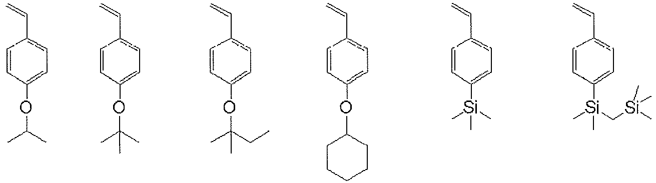

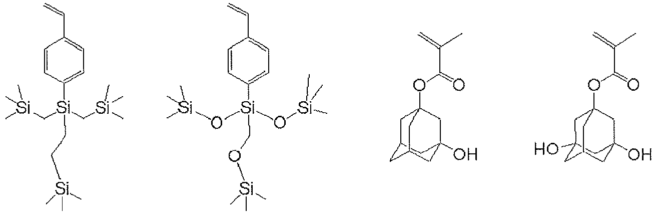

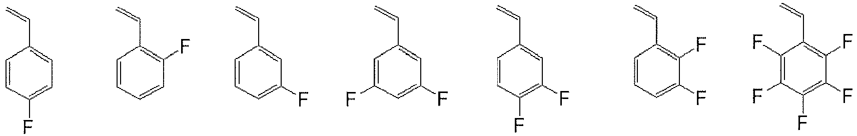

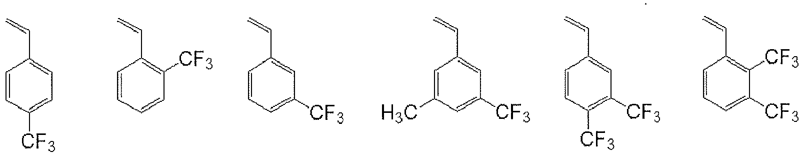

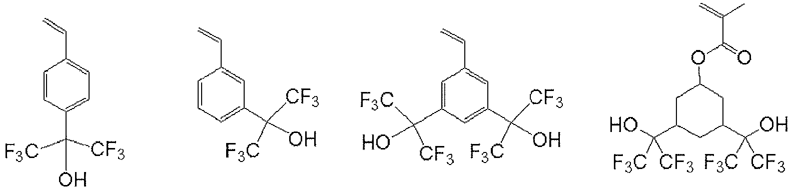

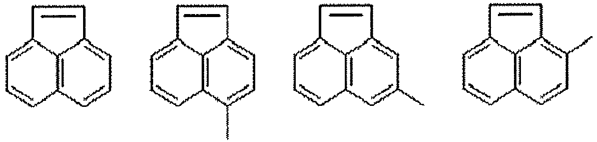

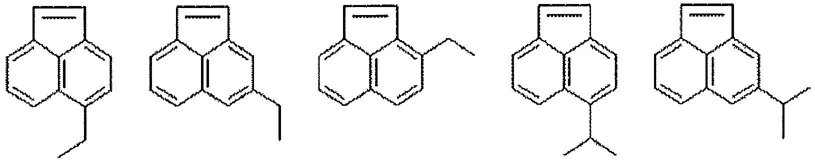

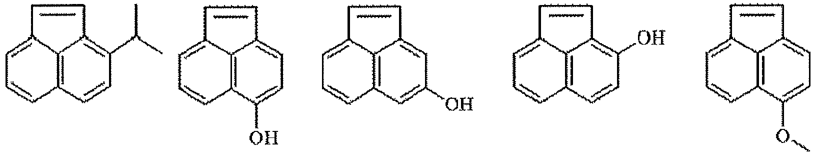

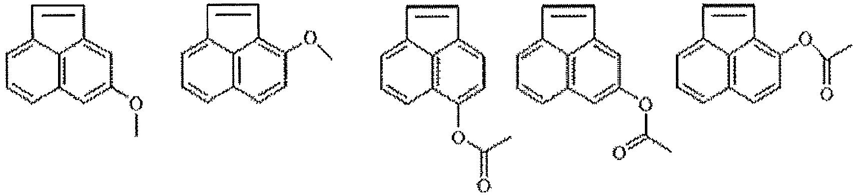

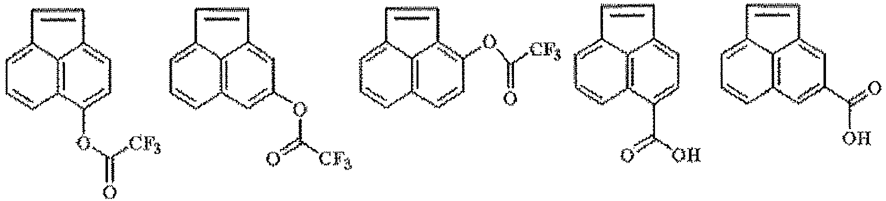

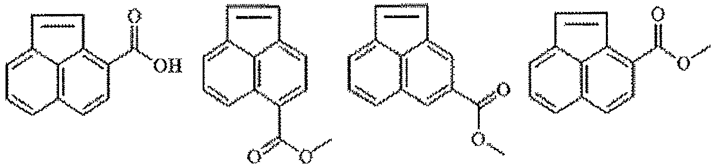

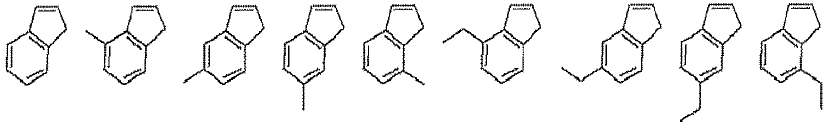

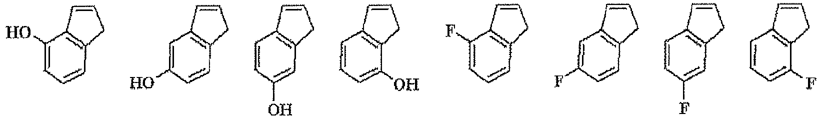

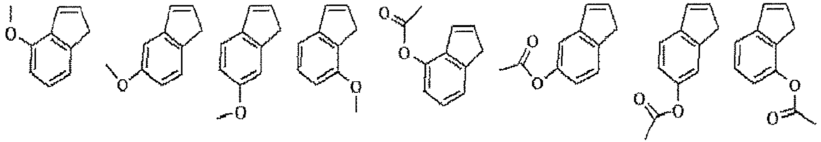

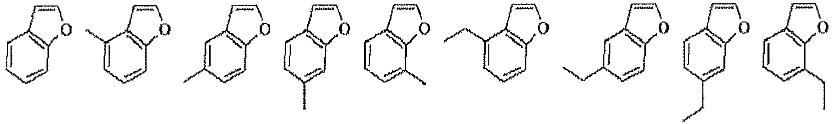

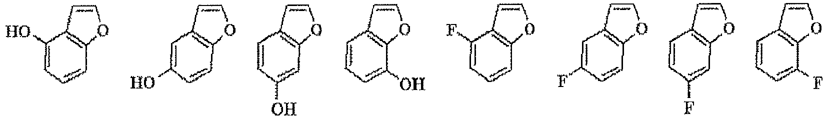

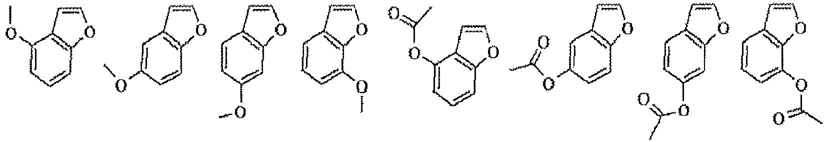

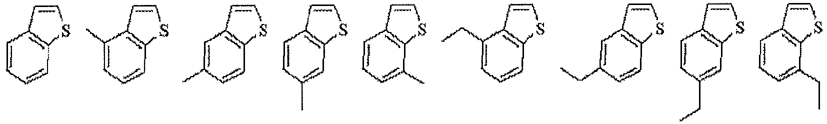

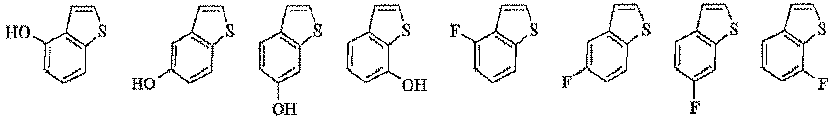

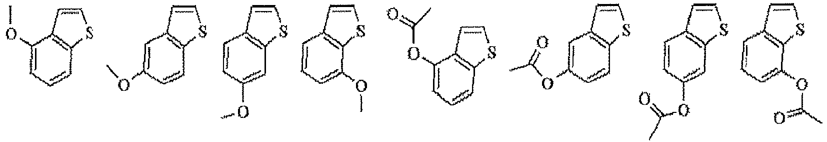

### (Synthesis Method of Component (B))

As a method for synthesizing the homopolymer of the component (B), for example, desired monomers among the above monomers to give the repeating units-b and -c are subjected to heat polymerization in an organic solvent by adding a radical polymerization initiator to obtain a dopant polymer of a (co)polymerizate.

As the organic solvent to be used for the polymerization, there may be exemplified by toluene, benzene, tetrahydrofuran, diethyl ether, dioxane, cyclohexane, cyclopentane, methyl ethyl ketone, γ-butyrolactone, etc.

As the radical polymerization initiator, there may be exemplified by 2,2'-azobisisobutyronitrile (AIBN), 2,2'-azobis(2,4-dimethylvaleronitrile), dimethyl 2,2'-azobis(2-methylpropionate), benzoyl peroxide, lauroyl peroxide, etc.

The reaction temperature in polymerization is preferably 50 to 80°C, and the reaction time is preferably 2 to 100 hours, more preferably 5 to 20 hours.

In the dopant polymer of the component (B), the monomer to give the repeating unit-b may be one kind or a combination of two or more kinds, and it is preferred to combine methacryl type and styrene type monomers to heighten polymerizability in case of adding the monomer to give the repeating unit-c.

In addition, when using two or more kinds of monomers to give the repeating unit-b or additionally using the repeating unit-c, each monomer can be copolymerized to a random copolymer or a block copolymer. When a block copolymerized polymer (block copolymer) is formed, it can be expected to obtain a merit that the electric conductivity is improved by aggregating the repeating unit portions comprising the two or more kinds of the repeating units-b with each other to form a sea-island structure and to generate a peculiar structure around the dopant polymer.

When a random copolymerization is to be carried out by a radical polymerization, it is general to use the method in which the monomers to be copolymerized and a radical polymerization initiator are mixed and polymerized by heating. In the case that the polymerization is started with a first monomer in the presence of a radical polymerization initiator, and then adding a second monomer thereto later, the resulting polymer has a structure in which one side of the polymer molecule is a structure that the first monomer is polymerized, and the other side is a structure that the second monomer is polymerized. However, in this case, the repeating units of the first monomer and the second monomer are mixedly present at the middle portion, which is different in the structure from the block copolymer. For forming the block copolymer by radical polymerization, the living radical polymerization is preferably used.

In a living radical polymerization method called RAFT polymerization (Reversible Addition Fragmentation chain Transfer polymerization), the radical at the polymer terminal is always living, so that it is possible to form a diblock copolymer comprising a block of a repeating unit of the first monomer and a block of a repeating unit of the second monomer by starting the polymerization with the first monomer, and then adding the second monomer at the stage when the first monomer has been consumed. In addition, it is also possible to form a triblock copolymer by starting the polymerization with the first monomer, then adding the second monomer at the stage when the first monomer has been consumed, and then adding the third monomer thereto.

When the RAFT polymerization is carried out, there is a characteristic that a narrowly distributed polymer having a narrow molecular weight distribution (degree of distribution) is formed, in particular, when the RAFT polymerization is carried out by adding the monomers at once, a polymer having a narrower molecular weight distribution can be formed.

The dopant polymer of the component (B) preferably has a narrow distribution, and the molecular weight distribution (Mw/Mn) thereof is preferably 1.0 to 2.0, particularly preferably 1.0 to 1.5. If the dopant polymer has a narrow distribution, it is possible to prevent lowering of the permeability of a conductive film formed from a conductive polymer composition using the dopant polymer.

To carry out the RAFT polymerization, a chain transfer agent is necessary, and specific examples thereof may be mentioned 2-cyano-2-propyl benzothioate, 4-cyano-4-phenylcarbonothioylthio pentanoic acid, 2-cyano-2-propyl dodecyltrithiocarbonate, 4-cyano-4-[(dodecylsulfanylthiocarbonyl)sulfanyl]pentanoic acid, 2-(dodecylthiocarbonothioylthio)-2-methylpropanoic acid, cyanomethyl dodecylthiocarbonate, cyanomethyl methyl (phenyl) carbamothioate, bis(thiobenzoyl) disulfide, and bis(dodecylsulfanylthiocarbonyl) disulfide. Among these, 2-cyano-2-propyl benzothioate is particularly preferred.

The dopant polymer of the component (B) has a weight-average molecular weight in a range of 1,000 to 500,000, preferably in a range of 2,000 to 200,000. The weight-average molecular weight less than 1,000 deteriorates the heat resistance, and worsens the homogeneity of a composite solution with the component (A). On the other hand, the weight-average molecular weight more than 500,000 causes lowering the electric conductivity and an increase of the viscosity to worsen the workability and to lower the dispersibility into water or an organic solvent.

It is to be noted that the weight-average molecular weight (Mw) is a measured value in terms of polyethylene oxide, polyethylene glycol, or polystyrene by gel permeation chromatography (GPC) using water, dimethylformamide (DMF), or tetrahydrofuran (THF) as a solvent.

As a monomer to give the repeating unit-b, which constitute the dopant polymer of the component (B), it is possible to use a monomer having a sulfo group, but it is also possible to use a lithium salt, sodium salt, potassium salt, ammonium salt, or sulfonium salt of the sulfo group as a monomer to carry out the polymerization reaction, and then to change to a sulfo group with using an ion-exchange resin after the polymerization.

### [(C) Amphoteric ion compound]

The conductive polymer composition of the present invention may contain an amphoteric ion compound as component (C). The amphoteric ion compound used for the present invention is preferably shown by the following general formula (3). The amphoteric ion compound may be used singly or in a mixture of two or more kinds.

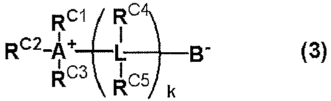

In the formula, R^{C1} to R^{C3} each independently represent a linear, branched, or cyclic monovalent hydrocarbon group having 1 to 20 carbon atoms and optionally substituted with or containing a heteroatom, or a hydrogen atom; R^{C1} and R^{C2}, or R^{C1}, R^{C2}, and R^{C3} may be bonded to each other to form a ring with A⁺ in the formula; A⁺ is a hetero atom and represents a monovalent cation; "k" is an integer of 1 to 8; L represents a carbon atom or a heteroatom, the both of which are optionally contained when "k" is 2 or more; R^{C4} and R^{C5} each represent a hydrogen atom, a hydroxy group, an amino group, or a linear, branched, or cyclic monovalent hydrocarbon group having 1 to 20 carbon atoms and optionally containing a heteroatom; R^{C4} and R^{C5} may be bonded to each other to form a ring, and adjoining R^{C4} may be bonded to each other to form a ring when "k" is 2 or more; R^{C4} and R^{C5} may be bonded to each other with an oxygen atom or a nitrogen atom to form a double bond, and when the double bond is formed with a nitrogen atom, the nitrogen atom may be an ion; L may be bonded with adjoining A⁺ to form a double bond, and adjoining L may form a double bond with each other when "k" is 2 or more; any of R^{C1} to R^{C3} may be bonded with R^{C4} or R^{C5} to form a ring; B⁻ is a monovalent anionic functional group and represents a carboxylate ion or a sulfonate ion.

In this case, it is further preferable that the component (C) be shown by the following general formula (4) : 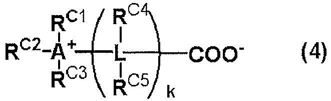 wherein R^{C1} to R^{C5}, A⁺, L, and "k" have the same meanings as defined above.

Among the amphoteric ion compound shown by the general formula (3), illustrative examples of compounds having a sulfonate ion specifically include the following.

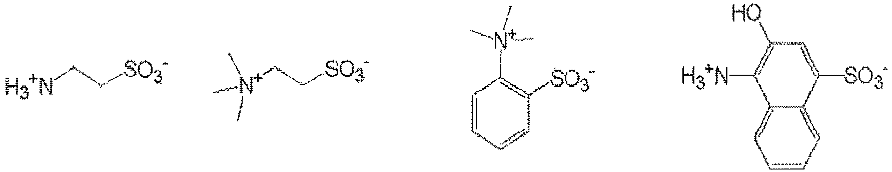

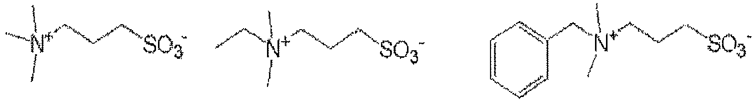

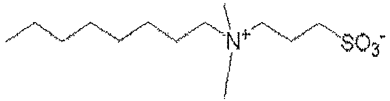

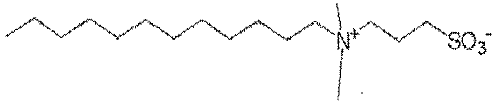

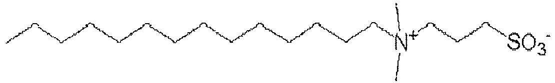

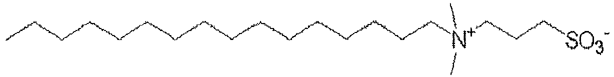

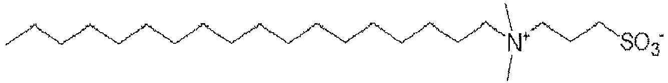

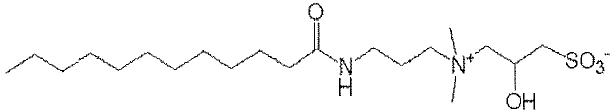

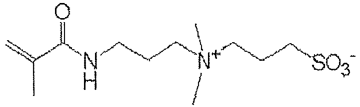

Among the amphoteric ion compounds shown by the general formula (4), illustrative examples of compounds having a carboxylate ion specifically include the following.

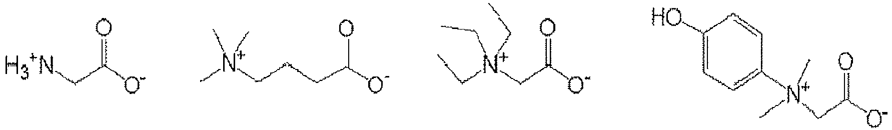

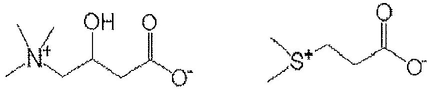

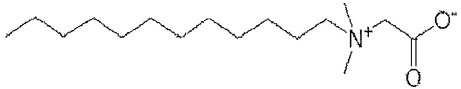

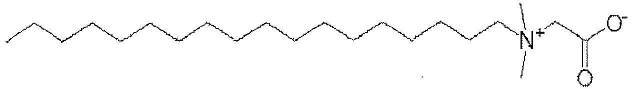

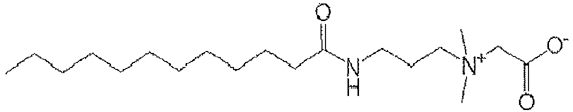

Illustrative examples of the amphoteric ion compound shown by the general formula (4) also include ionized amino acids shown below.

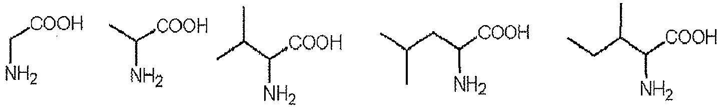

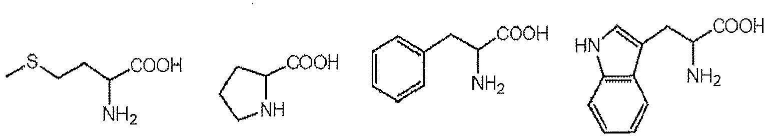

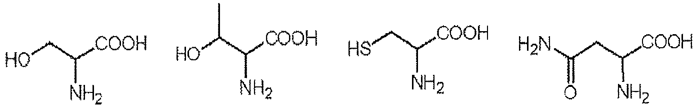

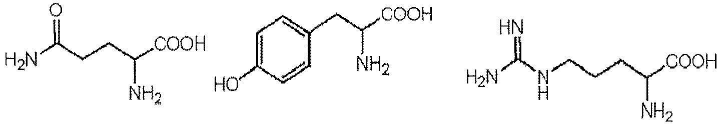

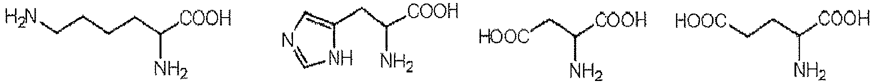

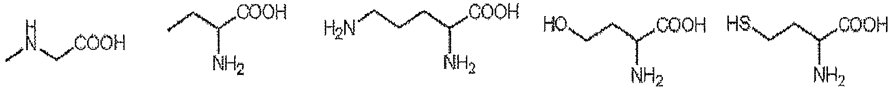

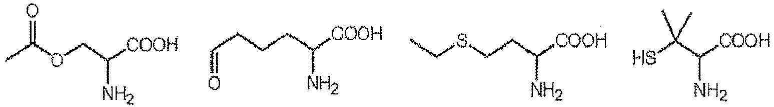

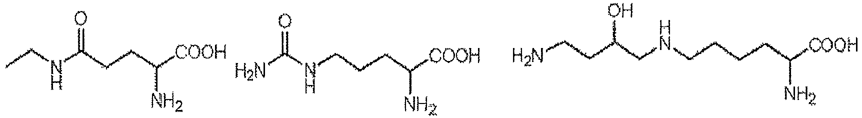

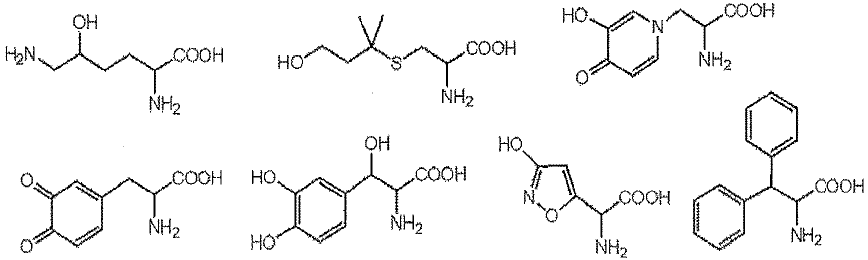

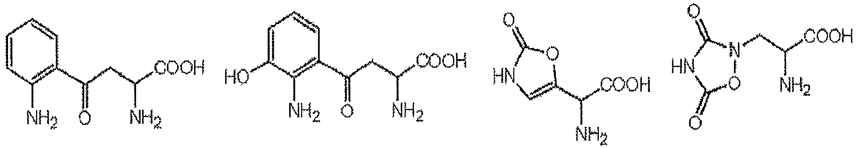

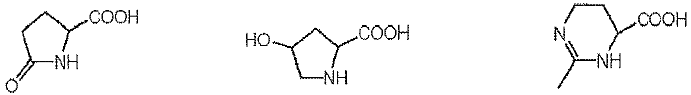

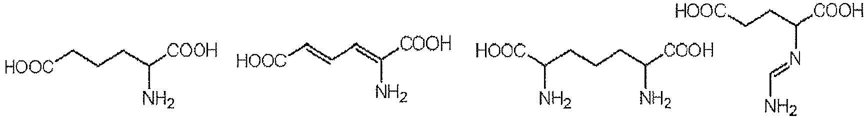

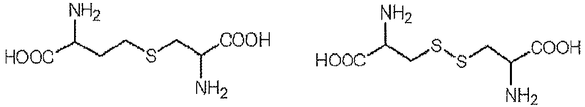

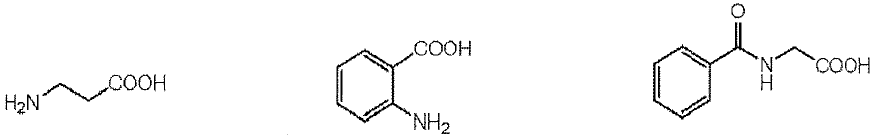

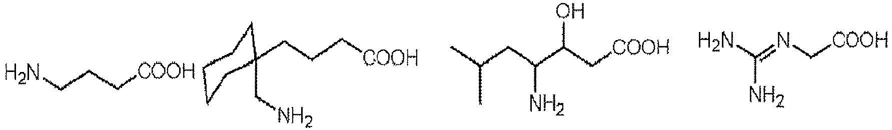

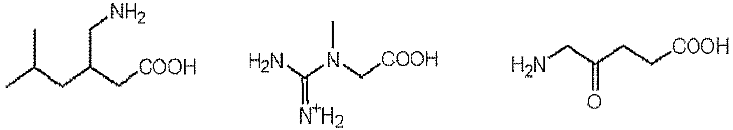

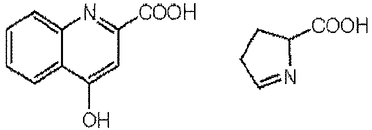

The content of the amphoteric ion compound (C) is preferably in the range of 1 to 70 parts by mass, more preferably 1 to 50 parts by mass, further preferably 20 to 50 parts by mass, and especially 20 to 40 parts by mass based on 100 parts by mass of the composite of the component (A) and the component (B). When the amphoteric ion compound is in such an amount, acid diffusion from the antistatic film formed by the inventive conductive polymer composition to the resist layer is decreased, so that the influence of an acid on lithography can be reduced while keeping the antistatic effect in electron beam drawing when the resist film is strongly influenced by the acid diffusion, and accordingly a resist pattern with higher resolution can be obtained. In case of the same kind of resist film, it is possible to obtain a resist body to be processed with small fluctuation in sensitivity over a period from immediately after the film forming on the resist film to pattern development.

### [Other components]

### (Surfactant)

In the present invention, a surfactant may be added to enhance the wettability to the body to be processed such as a substrate. As the surfactant, there may be mentioned various surfactants such as a nonionic type, a cationic type, an anionic type, etc. and nonionic surfactant is particularly preferable in view of stability of the conductive polymer. Illustrative examples thereof include nonionic surfactant, which is suitable, such as polyoxyethylene alkyl ether, polyoxyethylene alkyl phenyl ether, polyoxyethylene carboxylic acid ester, sorbitan ester, and polyoxyethylene sorbitan ester; cationic surfactant such as alkyltrimethylammonium chloride, alkylbenzylammonium chloride; anionic surfactant such as alkyl or alkylallyl sulfate salt, alkyl or alkylallyl sulfonate salt, and dialkyl sulfosuccinate salt; amphoteric surfactant such as amino acid type and betaine type. The blending amount of the surfactant is preferably 0.005 to 0.5% by mass, particularly 0.01 to 0.3% by mass.

The content of the nonionic surfactant is preferably in the range of 1 to 50 parts by mass, more preferably 1 to 30 parts by mass based on 100 parts by mass of the composite of the component (A) and the component (B). Such a content of the nonionic surfactant makes the wettability to the surface of a body to be processed more suitable, and gives the conductive film sufficient electric conductivity.

The inventive conductive polymer composition contains the polyaniline-based conductive polymer of the component (A), the dopant polymer of the component (B), and optionally the amphoteric ion compound of the component (C) described above, and the dopant polymer of the component (B) forms a composite (conductive polymer composite) through ionic bond to the polyaniline-based conductive polymer of the component (A).

The inventive conductive polymer composition can have a dispersibility to water or an organic solvent, and is able to improve the film-formability onto an inorganic or organic substrate (a substrate with an inorganic film or an organic film formed onto the surface) by spin coating and flatness of the film.

### [Production method of conductive polymer composition]

The composite of the component (A) and the component (B) (a conductive polymer composite) can be obtained by, for example, oxidative polymerization of two or more kinds of aniline monomers to be the raw materials of the component (A) added to an aqueous or water/organic solvent mixture solution of the component (B) through an addition of an oxidizing agent and an oxidation catalyst if needed.

Illustrative examples of the oxidizing agent and the oxidation catalyst include peroxodisulfate salts (persulfate salts) such as ammonium peroxodisulfate (ammonium persulfate), sodium peroxodisulfate (sodium persulfate), and potassium peroxodisulfate (potassium persulfate); transition metal compounds such as ferric chloride, ferric sulfate, and cupric chloride; metal oxides such as silver oxide and cesium oxide; peroxides such as hydrogen peroxide and ozone; organic peroxides such as benzoyl peroxide; and oxygen.

As the reaction solvent to be used for the oxidative polymerization, water or a mixture of water and a solvent may be used. As the solvent to be used here is preferably a solvent miscible with water and can dissolve or disperse the component (A) and the component (B). Illustrative examples thereof include alcohols such as methanol, ethanol, propanol, and butanol; polyvalent aliphatic alcohols such as ethylene glycol, propylene glycol, 1,3-propanediol, dipropylene glycol, 1,3-butylene glycol, 1,4-butylene glycol, D-glucose, D-glucitol, isoprene glycol, 1,2-butanediol, 1,3-butanediol, 1,4-butanediol, 2,3-butanediol, 1,2-pentanediol, 1,5-pentanediol, 1,2-hexanediol, 1,6-hexanediol, 1,9-nonanediol, and neopentyl glycol; chain ethers such as dialkyl ether, ethylene glycol monoalkyl ether, ethylene glycol dialkyl ether, propylene glycol monoalkyl ether, propylene glycol dialkyl ether, polyethylene glycol dialkyl ether, and polypropylene glycol dialkyl ether; cyclic ether compounds such as dioxane and tetrahydrofuran; polar solvents such as cyclohexanone, methyl amyl ketone, ethyl acetate, butanediol monomethyl ether, propylene glycol monomethyl ether, ethylene glycol monomethyl ether, butanediol monoethyl ether, propylene glycol monoethyl ether, ethylene glycol monoethyl ether, propylene glycol dimethyl ether, diethylene glycol dimethyl ether, propylene glycol monomethyl ether acetate, propylene glycol monoethyl ether acetate, ethyl pyruvate, butyl acetate, methyl 3-methoxypropionate, ethyl 3-ethoxypropionate, t-butyl acetate, t-butyl propionate, propylene glycol mono-t-butyl ether acetate, γ-butyrolactone, N-methyl-2-pyrrolidone, N,N'-dimethylformamide, N,N'-dimethylacetamide, dimethyl sulfoxide, and hexamethylenephosphor triamide; carbonate compounds such as ethylene carbonate and propylene carbonate; heterocyclic compounds such as 3-methyl-2-oxazolidinone; and nitrile compounds such as acetonitrile, glutaronitrile, methoxyacetonitrile, propionitrile, and benzonitrile. These solvents may be used singly or as a mixture of two or more of them. The blending amount of these water-miscible solvents is preferably 50% by mass or less with respect to entirety of the reaction solvents.

Note that the usage amount of the organic solvent is preferably 0 to 1,000 mL, particularly preferably 0 to 500 mL, relative to 1 mole of total monomers. Usage amounts of the organic solvent of 1,000 mL or less does not need large reaction vessels, thereby being economical.

Besides the dopant polymer of the component (B), it is possible to use another anion which can be doped into the polyaniline-based conductive polymer of the component (A). As to the anion like this, an organic acid is preferable in view of controlling the characteristic of de-doping from the polyaniline-based conductive polymer, as well as dispersibility, heat resistance, and environment resistance of the conductive polymer composition. As the organic acid, there may be mentioned an organic carboxylic acid, phenols, an organic sulfonic acid, etc.

As to the organic carboxylic acid, acids of aliphatic, aromatic, or alicyclic compound having one, or two or more carboxy groups may be used. Illustrative examples thereof include formic acid, acetic acid, oxalic acid, benzoic acid, phthalic acid, maleic acid, fumaric acid, malonic acid, tartaric acid, citric acid, lactic acid, succinic acid, monochloroacetic acid, dichloroacetic acid, trichloroacetic acid, trifluoroacetic acid, nitroacetic acid, and triphenylacetic acid. Illustrative examples of the phenols include cresol, phenol, and xylenol.

As to the organic sulfonic acid, aliphatic, aromatic, or alicyclic sulfonic acid having one, or two or more sulfo groups may be used. Illustrative examples of the compound having one sulfo group include sulfonic acid compounds such as methanesulfonic acid, ethanesulfonic acid, 1-propanesulfonic acid, 1-butanesulfonic acid, 1-hexanesulfonic acid, 1-heptanesulfonic acid, 1-octanesulfonic acid, 1-nonanesulfonic acid, 1-decanesulfonic acid, 1-dodecanesulfonic acid, 1-tetradecanesulfonic acid, 1-pentadecanesulfonic acid, 2-bromoethanesulfonic acid, 3-chloro-2-hydroxypropanesulfonic acid, trifluoromethanesulfonic acid, colistinmethanesulfonic acid, 2-acrylamide-2-methylpropanesulfonic acid, aminomethanesulfonic acid, 1-amino-2-naphthol-4-sulfonic acid, 2-amino-5-naphthol-7-sulfonic acid, 3-aminopropanesulfonic acid, N-cyclohexyl-3-aminopropanesulfonic acid, benzenesulfonic acid, p-toluenesulfonic acid, xylenesulfonic acid, ethylbenzenesulfonic acid, propylbenzenesulfonic acid, butylbenzenesulfonic acid, pentylbenzenesulfonic acid, hexylbenzenesulfonic acid, heptylbenzenesulfonic acid, octylbenzenesulfonic acid, nonylbenzenesulfonic acid, decylbenzenesulfonic acid, undecylbenzenesulfonic acid, dodecylbenzenesulfonic acid, pentadecylbenzenesulfonic acid, hexadecylbenzenesulfonic acid, 2,4-dimethylbenzenesulfonic acid, dipropylbenzenesulfonic acid, 4-aminobenzenesulfonic acid, o-aminobenzenesulfonic acid, m-aminobenzenesulfonic acid, 4-amino-2-chlorotoluene-5-sulfonic acid, 4-amino-3-methylbenzene-1-sulfonic acid, 4-amino-5-methoxy-2-methylbenzenesulfonic acid, 2-amino-5-methylbenzene-1-sulfonic acid, 4-amino-2-methylbenzene-1-sulfonic acid, 5-amino-2-methylbenzene-1-sulfonic acid, 4-acetamide-3-chlorobenzenesulfonic acid, 4-chloro-3-nitrobenzenesulfonic acid, p-chlorobenzenesulfonic acid, naphthalenesulfonic acid, methylnaphthalenesulfonic acid, propylnaphthalenesulfonic acid, butylnaphthalenesulfonic acid, pentylnaphthalenesulfonic acid, dimethylnaphthalenesulfonic acid, 4-amino-1-naphthalenesulfonic acid, 8-chloronaphthalene-1-sulfonic acid, polycondensation product of naphthalenesulfonic acid and formalin, and polycondensation product of melaminesulfonic acid and formalin.

Illustrative examples of the compound containing two or more sulfo groups include ethane disulfonic acid, butane disulfonic acid, pentane disulfonic acid, decane disulfonic acid, m-benzene disulfonic acid, o-benzene disulfonic acid, p-benzene disulfonic acid, toluene disulfonic acid, xylene disulfonic acid, chlorobenzene disulfonic acid, fluorobenzene disulfonic acid, aniline-2,4-disulfonic acid, aniline-2,5-disulfonic acid, diethylbenzene disulfonic acid, dibutylbenzene disulfonic acid, naphthalene disulfonic acid, methylnaphthalene disulfonic acid, ethylnaphthalene disulfonic acid, dodecylnaphthalene disulfonic acid, pentadecylnaphthalene disulfonic acid, butylnaphthalene disulfonic acid, 2-amino-1,4-benzene disulfonic acid, 1-amino-3,8-naphthalene disulfonic acid, 3-amino-1,5-naphthalene disulfonic acid, 8-amino-1-naphthol-3,6-disulfonic acid, 4-amino-5-naphthol-2,7-disulfonic acid, anthracene disulfonic acid, butylanthracene disulfonic acid, 4-acetamide-4'-isothiocyanatostilbene-2,2'-disulfonic acid, 4-acetamide-4'-maleimidylstilbene-2,2'-disulfonic acid, 1-acetoxypyrene-3,6,8-trisulfonic acid, 7-amino-1,3,6-naphthalene trisulfonic acid, 8-aminonaphthalene-1,3,6-trisulfonic acid, and 3-amino-1,5,7-naphthalene trisulfonic acid.

These anions other than the component (B) may be added into a solution containing a raw material monomer of the component (A), the component (B), and an oxidizing agent and/or an oxidative polymerization catalyst before polymerization of the component (A). Alternatively, it may be added into the conductive polymer composite (solution) which contains the component (A) after the polymerization and the component (B) .

The composite of the component (A) and the component (B) thus obtained may be used after being pulverized by a homogenizer, a ball mill, or the like, if necessary. For pulverization, a mixer/disperser which can apply a high shear force is preferably used. Illustrative examples of the mixer/disperser include a homogenizer, a high-pressure homogenizer, and a bead mill; among them, a high-pressure homogenizer is particularly preferable.

Illustrative examples of the high-pressure homogenizer include NanoVater (manufactured by Yoshida Kikai Co., Ltd.), Microfluidizer (manufactured by Powrex Corp.), and Ultimizer (manufactured by Sugino Machine Ltd.). As the dispersion treatment using the high-pressure homogenizer, there may be mentioned a treatment in which the composite solutions before the dispersion treatment are collided from the opposite direction with each other under high pressure, or a treatment in which the solution is passed through an orifice or a slit under high pressure.

Before or after the pulverization, impurities may be removed by the measures such as filtration, ultrafiltration, and dialysis; and also, purification may be done by using a cation-exchange resin, an anion-exchange resin, a chelate resin, or the like.

The total content of the component (A) and the component (B) in the conductive polymer composition solution is preferably in the range of 0.05 to 5.0% by mass. If the total content of the component (A) and the component (B) is 0.05% by mass or more, sufficient electric conductivity can be obtained; and if it is 5.0% by mass or less, the uniform conductive coating film can be readily obtained.

The content of the component (B) is preferably such an amount that the sulfo group in the component (B) is in the range of 0.1 to 10 mole, more preferably 1 to 7 mole, per 1 mole of total two or more kinds of aniline monomers that constitute the component (A). If the content of the sulfo group in the component (B) is 0.1 mole or more, the doping effect to the component (A) is so high that sufficient electric conductivity can be secured. On the other hand, if the content of the sulfo group in the component (B) is 10 mole or less, the content of the component (A) also becomes appropriate, so that sufficient electric conductivity can be obtained.

The inventive conductive polymer composition described above exhibits good filterability and film-formability, and can form a conductive film with good flatness and high electric conductivity.

The conductive polymer composition thus obtained can form a conductive film by applying it onto an electron beam resist or a body to be processed such as a substrate. Illustrative examples of the method of applying the conductive polymer composition include coating by a spin coater, a bar coater, soaking, comma coating, spray coating, roll coating, screen printing, flexographic printing, gravure printing, and ink jet printing. After applying, heat treatment by using a hot-air circulating furnace, a hot plate, or the like, or irradiation with IR light, UV light, or the like may be carried out, whereby the conductive film can be formed.

The inventive conductive polymer composition can be used for forming an antistatic film. The inventive conductive polymer composition has excellent electric conductivity and controlled acidity to lower the influence to the adjoined layer, and accordingly it can be used for an antistatic film in electron beam lithography drawing. In addition, it can be used for UV lithography or antistatic use for a film, glass, etc.

The inventive conductive polymer composition can also be suitably used as a material for forming a laminated film as a device constituent component in an organic thin-film device not only as an antistatic film regarding lithography. Furthermore, it can also be suitably used as a material for forming an electrode film such as a transparent electrode in an organic EL display, an organic EL illumination, a solar cell, etc. based on the excellent electric conductivity, film-formability, and transparency; or as a material for forming a carrier transferring film such as a carrier implanted layer and carrier transferring layer of an organic EL display, an organic EL illumination, and a solar cell in the same way based on the property to show highly efficient carrier transfer due to the n-conjugated network.

In constitution of an organic thin-film device, when the compound (C) is used in the inventive conductive polymer composition, the inventive conductive polymer composition, even when used as a layer for forming a multi-layer structure, does not adversely influence the adjoined layer by acid in the laminated structure. Accordingly, it is possible to avoid the deterioration and acid corrosion of materials constituting the adjoined layer at the interface after constructing the device. It is also possible to combine the adjoined layer which contains an organic/inorganic material having a reaction point with acid or metals corrodible with acid due to the low ionization energy.

As described above, the inventive conductive polymer composition can be applied to form a film onto a substrate, etc. The present invention provides a substrate having a conductive film or a carrier transferring film formed from the conductive polymer composition. The inventive conductive polymer composition can be suitably used for an antistatic film for lithography with use of electron beam, etc.; and can be suitably used for an electrode layer or a carrier transferring layer as a device constituent component in an organic thin-film device.

### <Coated Article>

The present invention also provides a coated article, comprising a film formed from the inventive conductive polymer composition on a body to be processed. The conductive film formed from the inventive conductive polymer composition is excellent in antistatic performance. Accordingly, high quality coated articles can be obtained by covering various bodies to be processed with these antistatic films.

Illustrative examples of the body to be processed include a glass substrate, a quartz substrate, a photomask blank substrate, a resin substrate, a silicon wafer, compound semiconductor wafers such as a gallium arsenic wafer and an indium phosphorous wafer, and a flexible substrate such as a resin film, an ultra-thin-film glass, and metal foil. The surfaces of these substrates may be coated with an organic or inorganic thin-film layer in order to flatten or insulate thereof, or to prevent permeation of gas or moisture.

As the coated article covered with a conductive film obtained from the conductive polymer composition of the present invention, illustrative examples include a glass substrate, a resin film, and a photoresist substrate, each of which is coated with the inventive conductive polymer composition as an antistatic film.

The inventive conductive polymer composition is also adaptable to an independent step of peeling an antistatic film or a step of peeling an antistatic film involved in a developing step in a process of electron beam resist drawing, thereby being favorably used even when the body to be processed is a substrate having a chemically amplified resist film, and giving more favorable results when the body to be processed is a substrate for obtaining a resist pattern by pattern irradiation with electron beam.

### <Patterning Process>

The present invention further provides a patterning process comprising the steps of:
forming an antistatic film on a chemically amplified resist film of a substrate having the chemically amplified resist film by using the inventive conductive polymer composition;
irradiating in a pattern with electron beam; and
developing with H₂O or an alkaline developer to obtain a resist pattern.

The patterning process can be performed in accordance with a conventional method except that the inventive conductive polymer composition is used, and the antistatic film formed from the conductive polymer composition can be peeled with H₂O before the heat treatment and after the electron beam drawing or can be peeled with a developer in a developing step of a resist pattern after the heating treatment. Naturally, other various steps such as an etching process can be performed after the development of a resist pattern.

According to such a patterning process, electrification phenomenon during exposure can be prevented, and a pattern having high sensitivity, high resolution, and good pattern profile can be obtained.

### EXAMPLE

Hereinafter, the present invention will be specifically described with reference to Synthesis Examples, Examples, and Comparative Examples, but the present invention is not restricted thereto.

The following Table 1 shows the structures of monomers to give repeating units to constitute (A) the polyaniline-based conductive polymer and monomers to give repeating units to constitute (B) the dopant polymer component used in Synthesis Examples, Examples, and Comparative Examples, together with the names thereof shown below.

**[Table 1]**

| | | | | | |
|---|---|---|---|---|---|
| A-1 | A-2 | A-3 | | | |
| 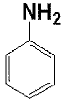 | 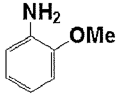 | 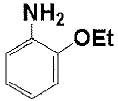 | | | |
| B-1 | B-2 | B-3 | B-4 | B-5 | B-6 |
| 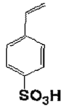 | 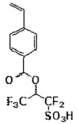 | 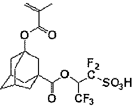 | 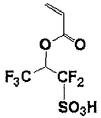 | 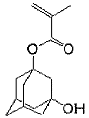 | 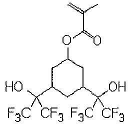 |

| | | | | | |
|---|---|---|---|---|---|
| A-1: aniline A-2: 2-methoxyaniline A-3: 2-ethoxyaniline B-1: styrene-4-sulfonic acid B-2: 1,1,3,3,3-pentafluoro-2-(4-vinylbenzoyloxy)-propane-1-sulfonate B-3: 1,1,3,3,3-pentafluoro-2-(3-methacryloyloxy-adamantane-1-carbonyloxy)-propane-1-sulfonate B-4: 1,1,3,3,3-pentafluoro-2-(3-methacryloyloxy)-propane-1-sulfonate B-5: 2-methyl-acrylic acid-3-hydroxyadamantane-1-yl ester B-6: 2-methyl-acrylic acid-3,5-bis(2,2,2-trifluoro-1-hydroxy-1-trifluoromethyl-ethyl)-cyclohexyl ester | | | | | |

To the composition containing a composite formed from the both components (A) and (B), (C) an amphoteric ion compound was added. The structure thereof before ionization is shown in Table 2.

**[Table 2]**

| |
|---|
| C-1 |
| 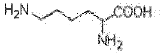 |

### [Synthesis Examples of Dopant Polymers]

### (Dopant polymer 1, not claimed)

Into 1,000 ml of deionized water, 206 g of the sodium salt of (B-1) was dissolved and stirred at 80°C. To this, oxidizing agent solution of 1.14 g ammonium persulfate previously dissolved to 10 ml of water was added dropwise for 20 minutes, and this solution was stirred for 2 hours.

To thus obtained solution, 1,000 ml of 10 mass% dilute sulfuric acid and 10,000 ml of deionized water were added. From this solution containing polymerized (B-1), about 10,000 ml of the solution was removed by ultrafiltration. To the remained liquid, 10,000 ml of deionized water was added, and about 10,000 ml of the solution was removed by ultrafiltration. This ultrafiltration was repeated for three times.

In addition, to the obtained filtrate, about 10,000 ml of deionized water was added, and about 10,000 ml of the solution was removed by ultrafiltration. This ultrafiltration was repeated for three times.

The obtained solution was subjected to reduced pressure to remove the water therein to give Dopant polymer 1, which was a colorless solid of polymerized (B-1). The obtained Dopant polymer 1 was analyzed by ¹H-NMR and GPC to determine the compositional ratio of copolymer (molar ratio), weight-average molecular weight (Mw), and molecular weight distribution (Mw/Mn).

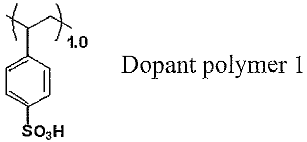

### (Dopant polymer 2)

Under nitrogen atmosphere, to 30.0g of methanol stirred at 64°C, the solution of 33.3 mmol of lithium salt of (B-1), 33.3 mmol of benzyltrimethylammonium salt of (B-2), and 6.66 mmol of dimethyl 2,2'-azobis(isobutyrate) in 90.0 g of methanol was added dropwise for 4 hours. This was stirred at 64°C for additional 4 hours. This was cooled to room temperature, and then added dropwise to 120 g of isopropyl ether with vigorous stirring. The formed solid was filtered off and dried in vacuum at 50°C for 15 hours to give 21.6 g of white polymer.

The obtained white polymer was dissolved to 160 g of methanol, and the ammonium salt and the lithium salt were converted to a sulfo group using ion-exchange resin. The obtained polymer was measured for the compositional ratio of copolymer (molar ratio), weight-average molecular weight (Mw), and molecular weight distribution (Mw/Mn) by ¹⁹F and ¹H-NMR as well as GPC.

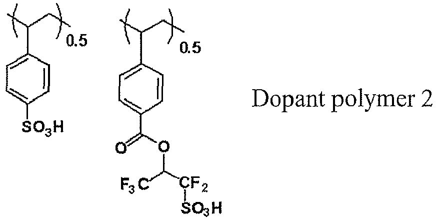

### (Dopant polymer 3)

The same synthesis procedure as in polymerizing Dopant polymer 2 was conducted except for using 20.0 mmol of lithium salt of (B-1) and 46.6 mmol of benzyltrimethylammonium salt of (B-2) to give 26.6 g of white polymer. The obtained white polymer was dissolved to 160 g of methanol, and the ammonium salt and the lithium salt were converted to a sulfo group using ion-exchange resin to give Dopant polymer 3. The obtained polymer was analyzed by ¹⁹F and ¹H-NMR as well as GPC to determine the compositional ratio of copolymer (molar ratio), weight-average molecular weight (Mw), and molecular weight distribution (Mw/Mn).

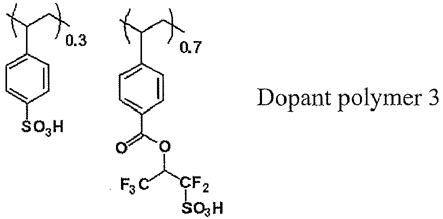

### (Dopant polymer 4)

The same synthesis procedure as in polymerizing Dopant polymer 2 was conducted except for using 46.6 mmol of lithium salt of (B-1) and 20.0 mmol of benzyltrimethylammonium salt of (B-2) to give 18.1 g of white polymer. The obtained white polymer was dissolved to 160 g of methanol, and the ammonium salt and the lithium salt were converted to a sulfo group using ion-exchange resin to give Dopant polymer 4. The obtained polymer was analyzed by ¹⁹F and ¹H-NMR as well as GPC to determine the compositional ratio of copolymer (molar ratio), weight-average molecular weight (Mw), and molecular weight distribution (Mw/Mn).

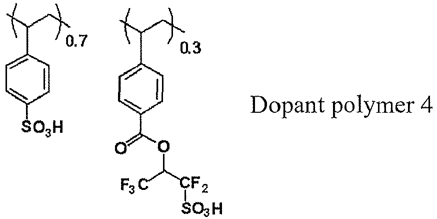

### (Dopant polymer 5)

The same synthesis procedure as in polymerizing Dopant polymer 2 was conducted except for using only 66.6 mmol of benzyltrimethylammonium salt of (B-2) to give 33.5 g of white polymer. The obtained white polymer was dissolved to 160 g of methanol, and the ammonium salt was converted to a sulfo group using ion-exchange resin to give Dopant polymer 5. The obtained polymer was analyzed by ¹⁹F and ¹H-NMR as well as GPC to determine the compositional ratio of copolymer (molar ratio), weight-average molecular weight (Mw), and molecular weight distribution (Mw/Mn).

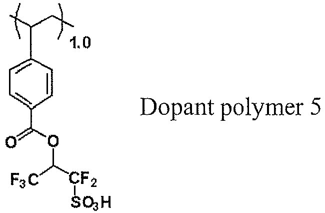

### (Dopant polymer 6)

The same synthesis procedure as in polymerizing Dopant polymer 2 was conducted except for using 33.3 mmol of lithium salt of (B-1) and 33.3 mmol of benzyltrimethylammonium salt of (B-3) to give 26.8 g of white polymer. The obtained white polymer was dissolved to 160 g of methanol, and the ammonium salt and the lithium salt were converted to a sulfo group using ion-exchange resin to give Dopant polymer 6. The obtained polymer was analyzed by ¹⁹F and ¹H-NMR as well as GPC to determine the compositional ratio of copolymer (molar ratio), weight-average molecular weight (Mw), and molecular weight distribution (Mw/Mn).

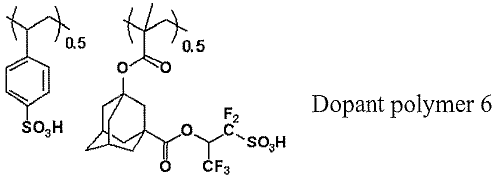

### (Dopant polymer 7)

The same synthesis procedure as in polymerizing Dopant polymer 2 was conducted except for using 20.0 mmol of lithium salt of (B-1) and 46.6 mmol of benzyltrimethylammonium salt of (B-3) to give 32.5 g of white polymer. The obtained white polymer was dissolved to 160 g of methanol, and the ammonium salt and the lithium salt were converted to a sulfo group using ion-exchange resin to give Dopant polymer 7. The obtained polymer was analyzed by ¹⁹F and ¹H-NMR as well as GPC to determine the compositional ratio of copolymer (molar ratio), weight-average molecular weight (Mw), and molecular weight distribution (Mw/Mn).

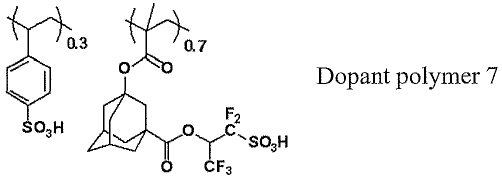

### (Dopant polymer 8)

The same synthesis procedure as in polymerizing Dopant polymer 2 was conducted except for using 46.6 mmol of lithium salt of (B-1) and 20.0 mmol of benzyltrimethylammonium salt of (B-3) to give 20.5 g of white polymer. The obtained white polymer was dissolved to 160 g of methanol, and the ammonium salt and the lithium salt were converted to a sulfo group using ion-exchange resin to give Dopant polymer 8. The obtained polymer was analyzed by ¹⁹F and ¹H-NMR as well as GPC to determine the compositional ratio of copolymer (molar ratio), weight-average molecular weight (Mw), and molecular weight distribution (Mw/Mn).

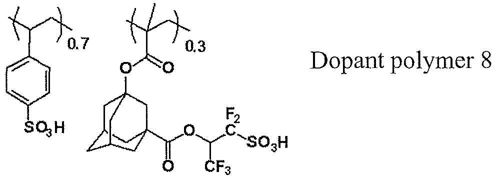

### (Dopant polymer 9)

The same synthesis procedure as in polymerizing Dopant polymer 2 was conducted except for using only 66.6 mmol of benzyltrimethylammonium salt of (B-3) to give 41.5 g of white polymer. The obtained white polymer was dissolved to 160 g of methanol, and the ammonium salt was converted to a sulfo group using ion-exchange resin to give Dopant polymer 9. The obtained polymer was analyzed by ¹⁹F and ¹H-NMR as well as GPC to determine the compositional ratio of copolymer (molar ratio), weight-average molecular weight (Mw), and molecular weight distribution (Mw/Mn).

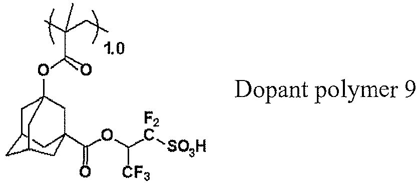

### (Dopant polymer 10)

The same synthesis procedure as in polymerizing Dopant polymer 2 was conducted except for using 33.3 mmol of lithium salt of (B-1) and 33.3 mmol of benzyltrimethylammonium salt of (B-4) to give 25.8 g of white polymer. The obtained white polymer was dissolved to 160 g of methanol, and the ammonium salt and the lithium salt were converted to a sulfo group using ion-exchange resin to give Dopant polymer 10. The obtained polymer was analyzed by ¹⁹F and ¹H-NMR as well as GPC to determine the compositional ratio of copolymer (molar ratio), weight-average molecular weight (Mw), and molecular weight distribution (Mw/Mn).

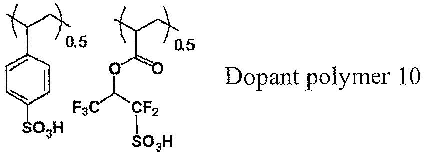

### (Dopant polymer 11)

The same synthesis procedure as in polymerizing Dopant polymer 2 was conducted except for using 20.0 mmol of lithium salt of (B-1) and 46.6 mmol of benzyltrimethylammonium salt of (B-4) to give 32.3 g of white polymer. The obtained white polymer was dissolved to 160 g of methanol, and the ammonium salt and the lithium salt were converted to a sulfo group using ion-exchange resin to give Dopant polymer 11. The obtained polymer was analyzed by ¹⁹F and ¹H-NMR as well as GPC to determine the compositional ratio of copolymer (molar ratio), weight-average molecular weight (Mw), and molecular weight distribution (Mw/Mn).

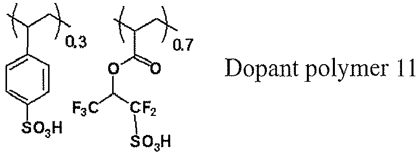

### (Dopant polymer 12)

The same synthesis procedure as in polymerizing Dopant polymer 2 was conducted except for using 46.6 mmol of lithium salt of (B-1) and 20.0 mmol of benzyltrimethylammonium salt of (B-4) to give 21.0 g of white polymer. The obtained white polymer was dissolved to 160 g of methanol, and the ammonium salt and the lithium salt were converted to a sulfo group using ion-exchange resin to give Dopant polymer 12. The obtained polymer was analyzed by ¹⁹F and ¹H-NMR as well as GPC to determine the compositional ratio of copolymer (molar ratio), weight-average molecular weight (Mw), and molecular weight distribution (Mw/Mn).

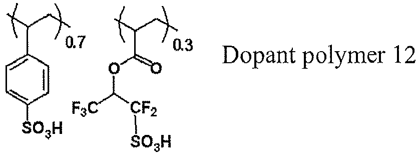

### (Dopant polymer 13)

The same synthesis procedure as in polymerizing Dopant polymer 2 was conducted except for using only 66.6 mmol of benzyltrimethylammonium salt of (B-4) to give 28.8 g of white polymer. The obtained white polymer was dissolved to 160 g of methanol, and the ammonium salt was converted to a sulfo group using ion-exchange resin to give Dopant polymer 13. The obtained polymer was analyzed by ¹⁹F and ¹H-NMR as well as GPC to determine the compositional ratio of copolymer (molar ratio), weight-average molecular weight (Mw), and molecular weight distribution (Mw/Mn).

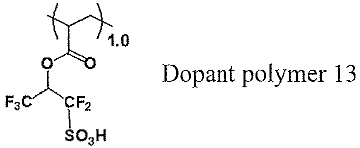

### (Dopant polymer 14)

Under nitrogen atmosphere, to 30.0g of methanol stirred at 64°C, the solution of 26.6 mmol of lithium salt of (B-1), 26.6 mmol of benzyltrimethylammonium salt of (B-2), 13.4 mmol of (B-5), and 6.66 mmol of dimethyl 2,2'-azobis(isobutyrate) in 90.0 g of methanol was added dropwise for 4 hours. This was stirred at 64°C for additional 4 hours. This was cooled to room temperature, and then added dropwise to 120 g of isopropyl ether with vigorous stirring. The formed solid was filtered off and dried in vacuum at 50°C for 15 hours to give 21.6 g of polymer. The obtained white polymer was dissolved to 160 g of methanol, and the ammonium salt and the lithium salt were converted to a sulfo group using ion-exchange resin to give Dopant polymer 14. The obtained polymer was analyzed by ¹⁹F and ¹H-NMR as well as GPC to determine the compositional ratio of copolymer (molar ratio), weight-average molecular weight (Mw), and molecular weight distribution (Mw/Mn).

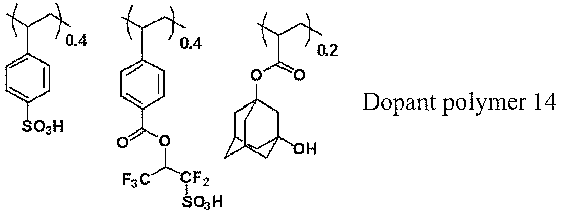

### (Dopant polymer 15)

The same synthesis procedure as in polymerizing Dopant polymer 14 was conducted except for using 26.6 mmol of lithium salt of (B-1), 26.6 mmol of benzyltrimethylammonium salt of (B-3), and 13.4 mmol of (B-5) to give 24.5 g of white polymer. The obtained white polymer was dissolved to 160 g of methanol, and the ammonium salt and the lithium salt were converted to a sulfo group using ion-exchange resin to give Dopant polymer 15. The obtained polymer was analyzed by ¹⁹F and ¹H-NMR as well as GPC to determine the compositional ratio of copolymer (molar ratio), weight-average molecular weight (Mw), and molecular weight distribution (Mw/Mn).

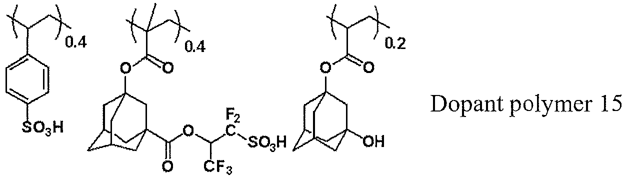

### (Dopant polymer 16)

The same synthesis procedure as in polymerizing Dopant polymer 14 was conducted except for using 26.6 mmol of lithium salt of (B-1), 26.6 mmol of benzyltrimethylammonium salt of (B-4), and 13.4 mmol of (B-5) to give 19.5 g of white polymer. The obtained white polymer was dissolved to 160 g of methanol, and the ammonium salt and the lithium salt were converted to a sulfo group using ion-exchange resin to give Dopant polymer 16. The obtained polymer was analyzed by ¹⁹F and ¹H-NMR as well as GPC to determine the compositional ratio of copolymer (molar ratio), weight-average molecular weight (Mw), and molecular weight distribution (Mw/Mn).

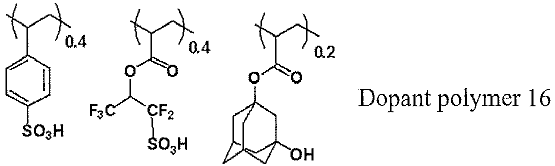

### (Dopant polymer 17)

The same synthesis procedure as in polymerizing Dopant polymer 14 was conducted except for using 26.6 mmol of lithium salt of (B-1), 26.6 mmol of benzyltrimethylammonium salt of (B-2), and 13.4 mmol of (B-6) to give 25.0 g of white polymer. The obtained white polymer was dissolved to 160 g of methanol, and the ammonium salt and the lithium salt were converted to a sulfo group using ion-exchange resin to give Dopant polymer 17. The obtained polymer was analyzed by ¹⁹F and ¹H-NMR as well as GPC to determine the compositional ratio of copolymer (molar ratio), weight-average molecular weight (Mw), and molecular weight distribution (Mw/Mn).

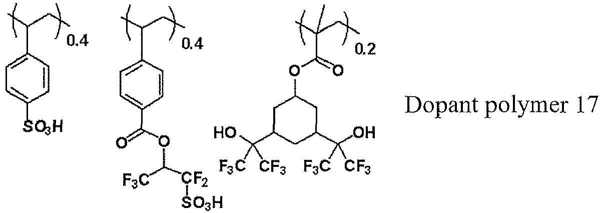

### (Dopant polymer 18)

The same synthesis procedure as in polymerizing Dopant polymer 14 was conducted except for using 26.6 mmol of lithium salt of (B-1), 26.6 mmol of benzyltrimethylammonium salt of (B-3), and 13.4 mmol of (B-6) to give 24.7 g of white polymer. The obtained white polymer was dissolved to 160 g of methanol, and the ammonium salt and the lithium salt were converted to a sulfo group using ion-exchange resin to give Dopant polymer 18. The obtained polymer was analyzed by ¹⁹F and ¹H-NMR as well as GPC to determine the compositional ratio of copolymer (molar ratio), weight-average molecular weight (Mw), and molecular weight distribution (Mw/Mn).

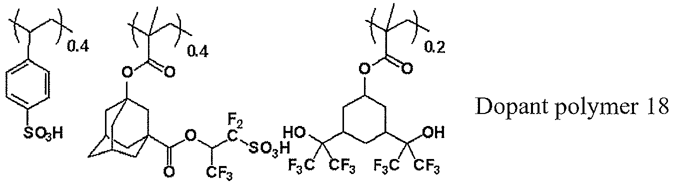

### (Dopant polymer 19)

The same synthesis procedure as in polymerizing Dopant polymer 14 was conducted except for using 26.6 mmol of lithium salt of (B-1), 26.6 mmol of benzyltrimethylammonium salt of (B-4), and 13.4 mmol of (B-6) to give 20.2 g of white polymer. The obtained white polymer was dissolved to 160 g of methanol, and the ammonium salt and the lithium salt were converted to a sulfo group using ion-exchange resin to give Dopant polymer 19. The obtained polymer was analyzed by ¹⁹F and ¹H-NMR as well as GPC to determine the compositional ratio of copolymer (molar ratio), weight-average molecular weight (Mw), and molecular weight distribution (Mw/Mn).

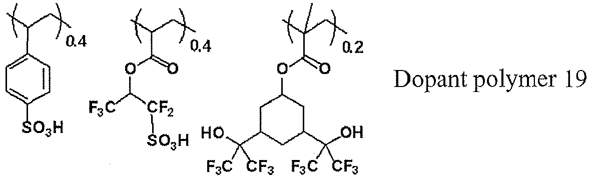

Table 3 shows the compositional ratio of repeating units of copolymer (%), weight-average molecular weight (Mw), and molecular weight distribution (Mw/Mn) of the polymerized Dopant polymers 1 to 19.

**[Table 3]**

| | Repeating Unit 1 | | Repeating Unit 2 | | Repeating Unit 3 | | weight-average molecular weight (Mw) | Molecular weight distribution (Mw/Mn) |
|---|---|---|---|---|---|---|---|---|
| | | Ratio (%) | | Ratio (%) | | Ratio (%) | | |
| Dopant polymer 1 | B-1 | 100 | - | - | - | - | 37,000 | 1.92 |
| Dopant polymer 2 | B-1 | 50 | B-2 | 50 | - | - | 41,500 | 1.90 |
| Dopant polymer 3 | B-1 | 30 | B-2 | 70 | - | - | 36,000 | 2.10 |
| Dopant polymer 4 | B-1 | 70 | B-2 | 30 | - | - | 33,500 | 2.89 |
| Dopant polymer 5 | B-2 | 100 | - | - | - | - | 29,000 | 1.88 |
| Dopant polymer 6 | B-1 | 50 | B-3 | 50 | - | - | 42,000 | 1. 98 |
| Dopant polymer 7 | B-1 | 30 | B-3 | 70 | - | - | 40,500 | 2.00 |
| Dopant polymer 8 | B-1 | 70 | B-3 | 30 | - | - | 39,800 | 1.76 |
| Dopant polymer 9 | B-3 | 100 | - | - | - | - | 30,400 | 1.87 |
| Dopant polymer 10 | B-1 | 50 | B-4 | 50 | - | - | 36,400 | 1.98 |
| Dopant polymer 11 | B-1 | 30 | B-4 | 70 | - | - | 35,500 | 1.87 |
| Dopant polymer 12 | B-1 | 70 | B-4 | 30 | - | - | 32,300 | 1.86 |
| Dopant polymer 13 | B-4 | 100 | - | - | - | - | 39,500 | 2.00 |
| Dopant polymer 14 | B-1 | 40 | B-2 | 40 | B-5 | 20 | 42,500 | 2.53 |
| Dopant polymer 15 | B-1 | 40 | B-3 | 40 | B-5 | 20 | 39,800 | 2.44 |
| Dopant polymer 16 | B-1 | 40 | B-4 | 40 | B-5 | 20 | 35,700 | 2.21 |
| Dopant polymer 17 | B-1 | 40 | B-2 | 40 | B-6 | 20 | 32,000 | 2.10 |
| Dopant polymer 18 | B-1 | 40 | B-3 | 40 | B-6 | 20 | 31,500 | 2.33 |
| Dopant polymer 19 | B-1 | 40 | B-4 | 40 | B-6 | 20 | 31,000 | 2.40 |

### [Synthesis Example of Conductive Polymer Composite containing Aniline and Dopant Polymer]

The following are Synthesis Examples 1 to 76 of conductive polymer composites containing aniline and Dopant polymer using aniline monomers of repeating units to constitute (A) the polyaniline-based conductive polymer and the component (B) Dopant polymers 1 to 19 to form a composite with (A).

### (Synthesis Example 1)

At 25°C, 213.8 mmol of (A-1) and 11.3 mmol of (A-2) were mixed to the solution of 225.0 mmol of Dopant polymer 1 dissolved in 1,000mL of ultrapure water.

Thus obtained mixed solution was kept at 0°C, and 202.5 mmol of ammonium persulfate dissolved in 200 mL of ultrapure water was slowly added thereto with stirring. These were allowed to react with stirring.

The obtained reaction solution was concentrated and added dropwise to 4,000 mL of acetone to give green powder. This green powder was dispersed to 1,000 mL of ultrapure water again, and this was added dropwise to 4,000 mL of acetone to purify and recrystallize out the green powder. This procedure was repeated for three times, and the obtained green powder was dispersed to 2,000 mL of ultrapure water again, and about 1,000 mL of water was removed by ultrafiltration. This procedure was repeated for 10 times to give Polyaniline conductive polymer composite 1. The conditions of the ultrafiltration were as follows.

Cut-off molecular weight of the ultrafiltration membrane: 10K
Cross-flow method
Flow rate of supply solution: 3,000 mL/min
Partial membrane pressure: 0.12Pa

### (Synthesis Examples 2 to 19)

The same procedure as in synthesizing Polyaniline conductive polymer composite 1 was conducted except for using the same amounts of (A-1) and (A-2) as in Synthesis Example 1, together with Dopant polymers 2 to 19 in the same mole amounts to give conductive polymer composites.

### (Synthesis Example 20)

The same procedure as in synthesizing Polyaniline conductive polymer composite 1 was conducted except for using 180.0 mmol of (A-1) and 45.0 mmol of (A-2) to give a conductive polymer composite.

### (Synthesis Examples 21 to 38)

The same procedure as in synthesizing Polyaniline conductive polymer composite 1 was conducted except for using the same amounts of (A-1) and (A-2) as in Synthesis Example 20, together with Dopant polymers 2 to 19 in the same mole amounts to give conductive polymer composites.

### (Synthesis Example 39)

The same procedure as in synthesizing Polyaniline conductive polymer composite 1 was conducted except for using 213.8 mmol of (A-1) and 11.3 mmol of (A-3) to give a conductive polymer composite.

### (Synthesis Examples 40 to 57)

The same procedure as in synthesizing Polyaniline conductive polymer composite 1 was conducted except for using the same amounts of (A-1) and (A-3) as in Synthesis Example 39, together with Dopant polymers 2 to 19 in the same mole amounts to give conductive polymer composites.

### (Synthesis Example 58)

The same procedure as in synthesizing Polyaniline conductive polymer composite 1 was conducted except for using 180.0 mmol of (A-1) and 45.0 mmol of (A-3) to give a conductive polymer composite.

### (Synthesis Examples 59 to 76)

The same procedure as in synthesizing Polyaniline conductive polymer composite 1 was conducted except for using the same amounts of (A-1) and (A-3) as in Synthesis Example 58, together with Dopant polymers 2 to 19 in the same mole amounts to give conductive polymer composites.

Tables 4 and 5 show the compositional ratio of the repeating units of the component (A) and combination of the component (B) in Synthesis Examples 1 to 76.

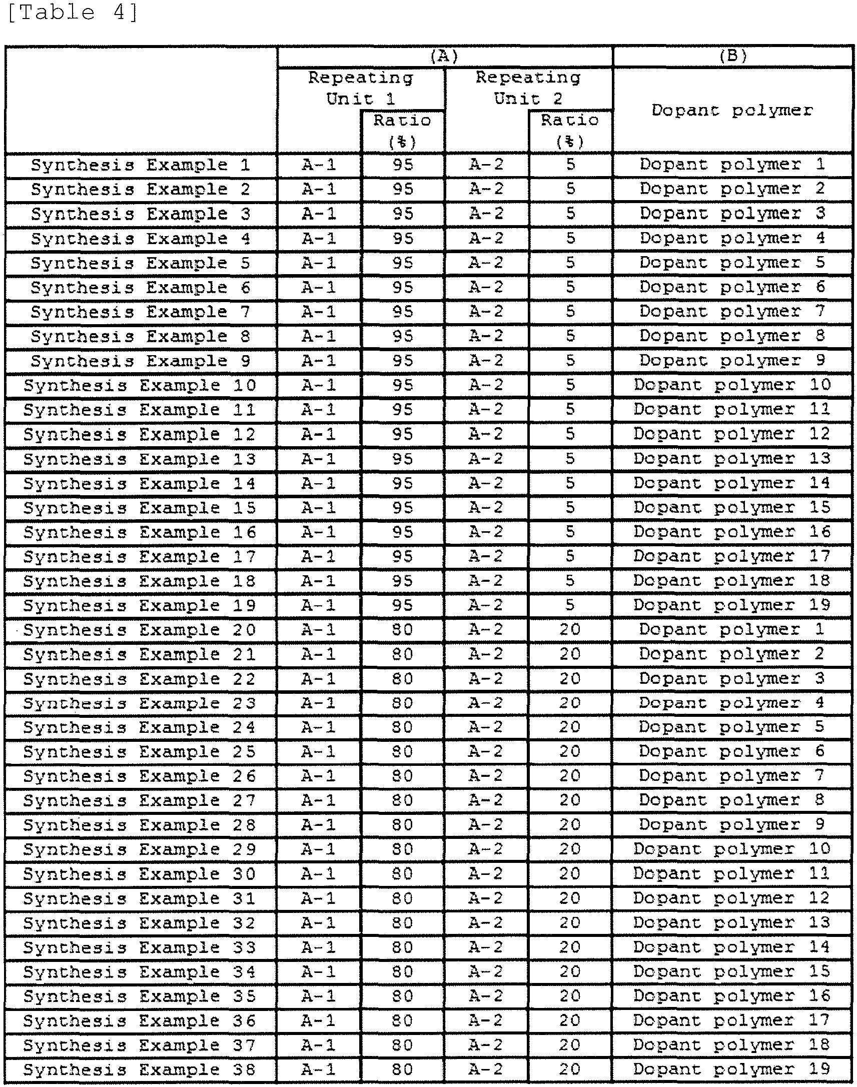

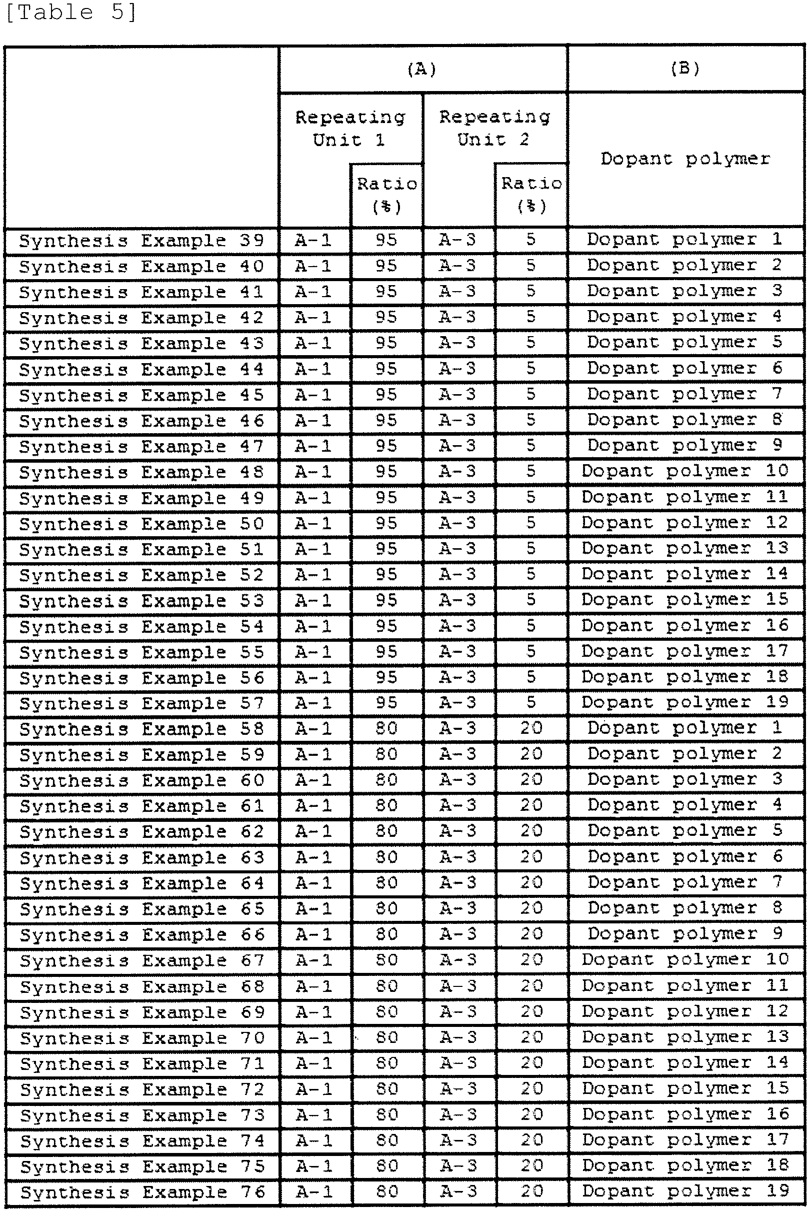

### [Preparation of Conductive Polymer Composite Composition containing Polyaniline-based Conductive Polymer]

As Preparation Examples 1 to 76, each of the green powder of the polyaniline-based conductive composites obtained in Synthesis Examples 1 to 76 was dispersed to ultrapure water in which acetylene glycol-base surfactant Surfynol 465 (manufactured by Nissin Chemical Industry Co., Ltd.) had been dissolved to have a concentration of 3.5 wt% to prepare Preparation liquids 1 to 76. As Preparation Examples 77 to 152, the component (C) amphoteric ion compound was added to Preparation liquids 1 to 76. Tables 6 and 7 show the composition and combination in Preparation Examples 1 to 76, and Tables 8 and 9 show the composition and combination in Preparation Examples 77 to 152.

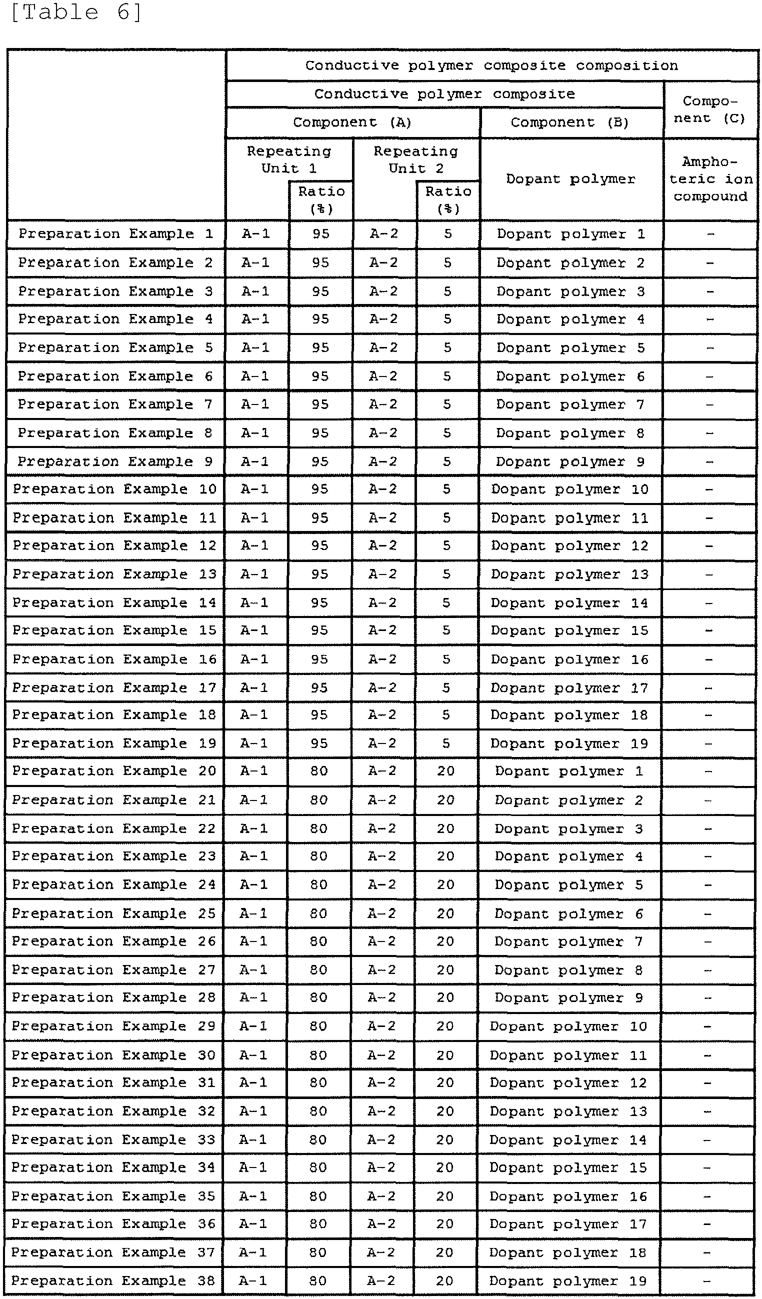

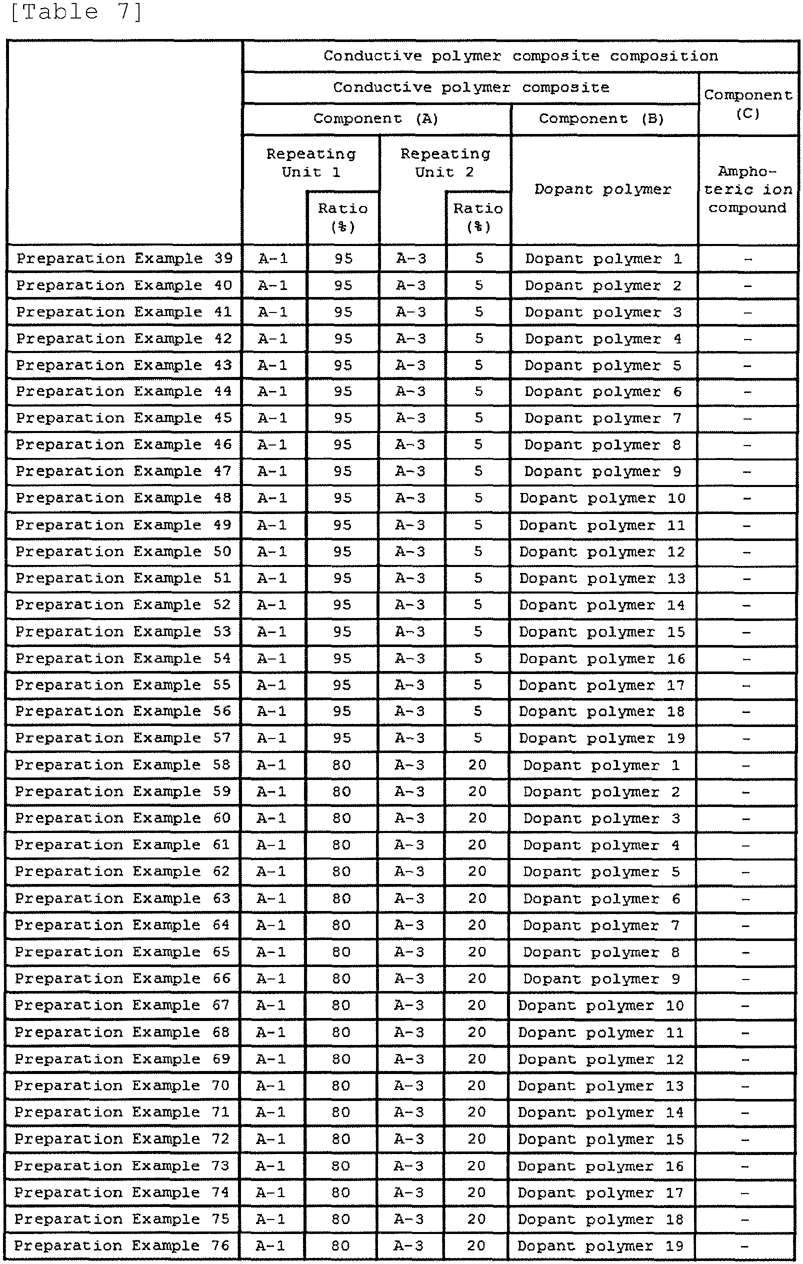

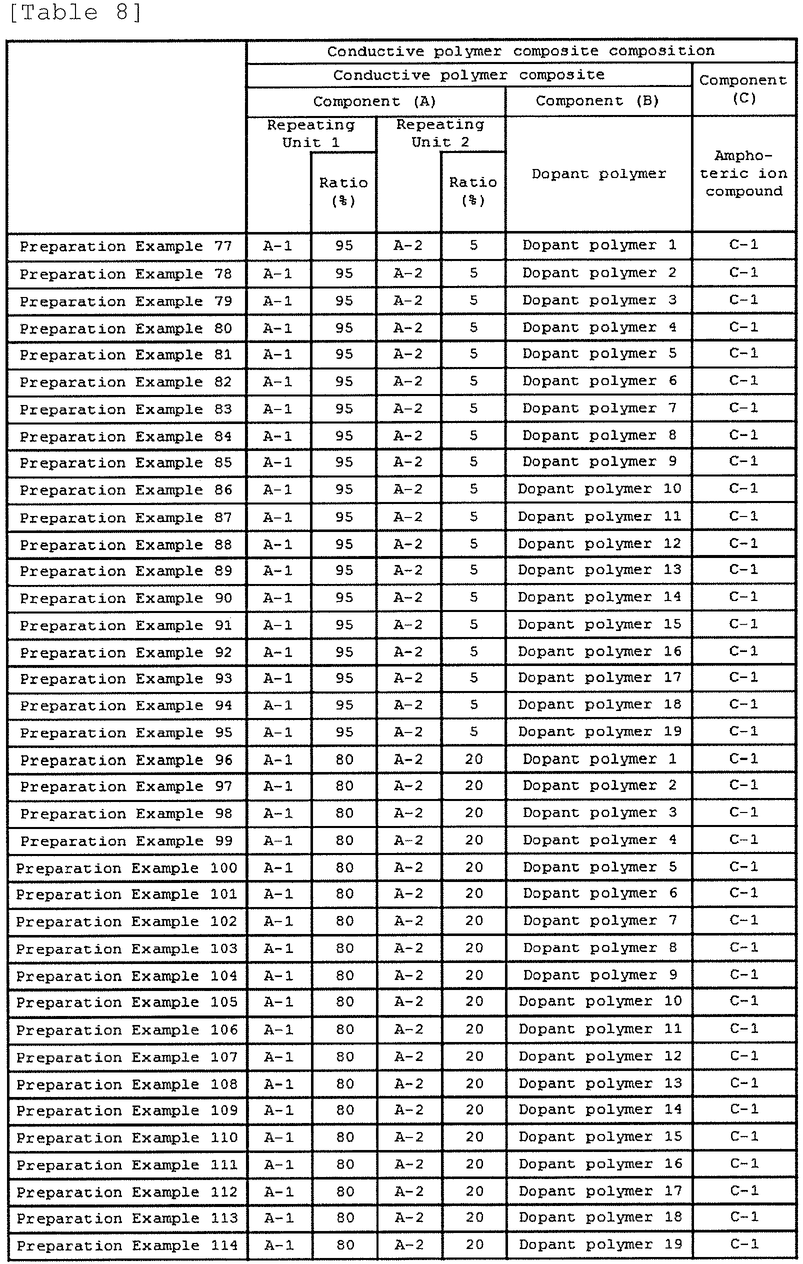

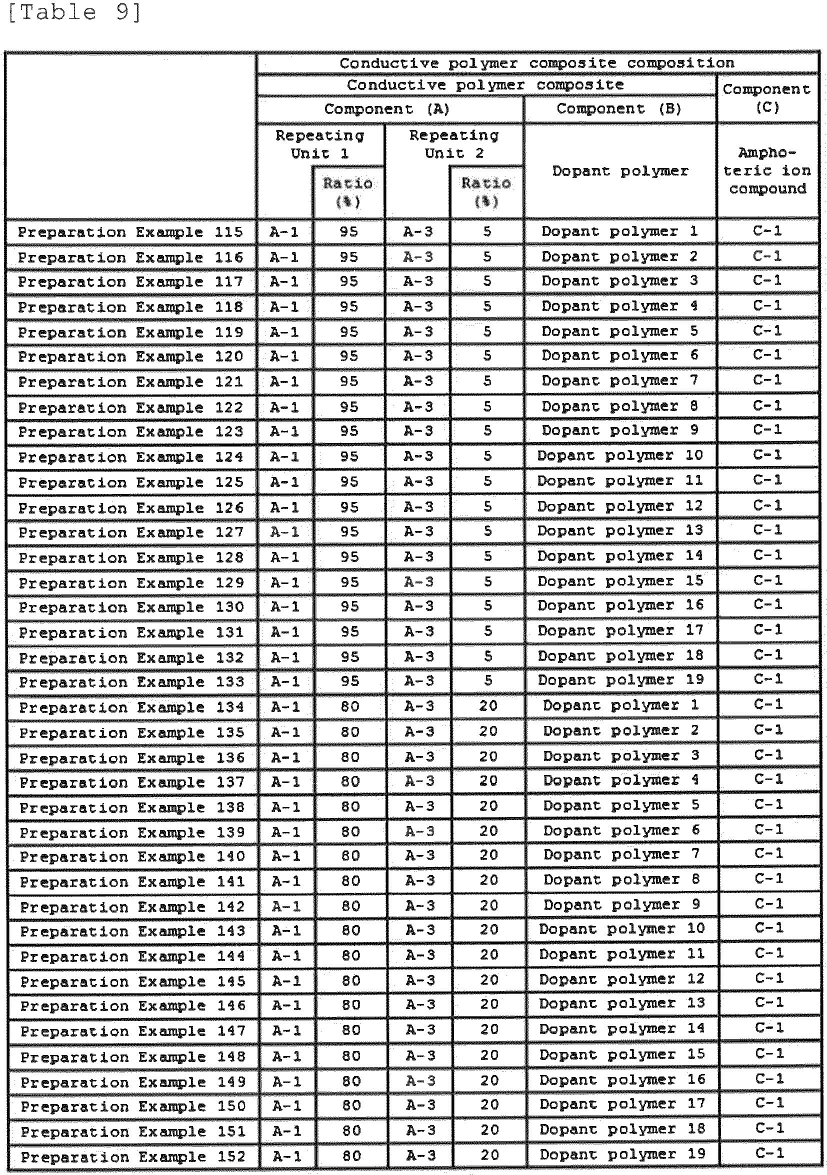

Preparation examples 1, 20, 39, 58, 77, 96, 115 and 134 are not claimed.

### [Comparative Synthesis Example of Conductive Polymer Composite containing Aniline and Dopant Polymer]

Table 10 shows Comparative Synthesis Examples 1 to 57 of conductive polymer composites containing aniline and Dopant polymer using aniline monomers of repeating units to constitute (A) the polyaniline-based conductive polymer and the component (B) Dopant polymers 1 to 19 to form a composite with (A).

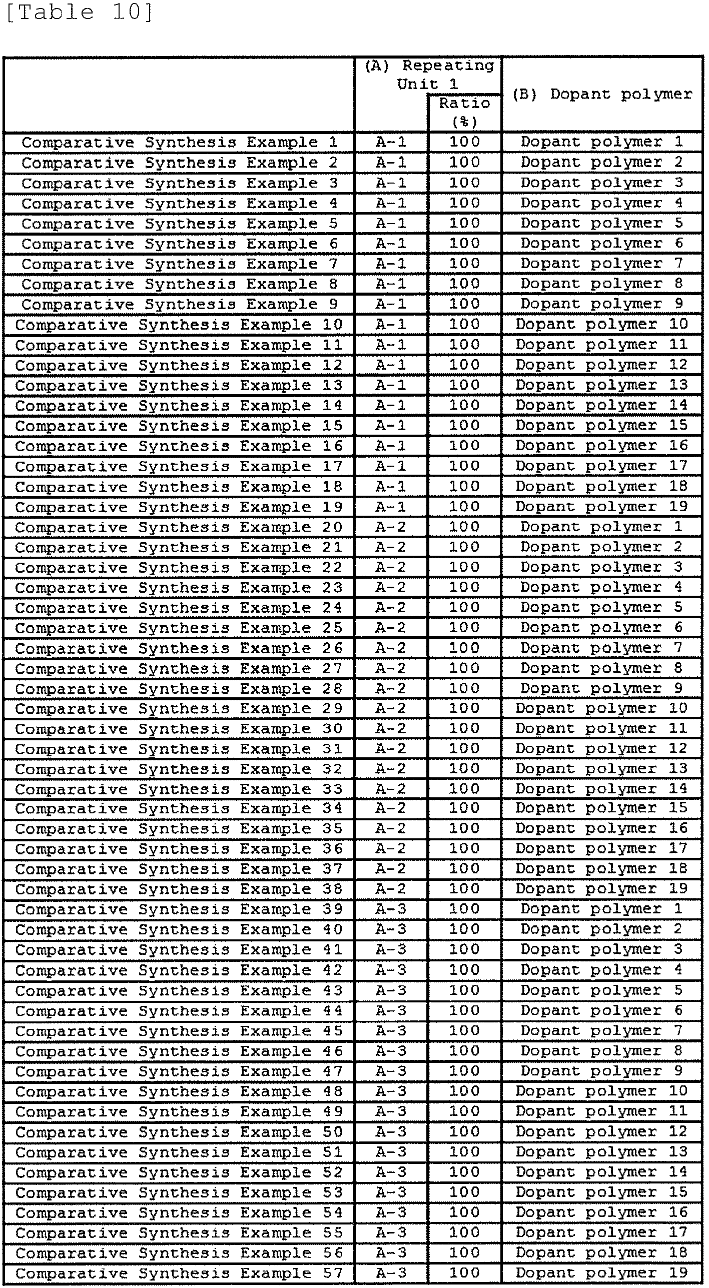

### (Comparative Synthesis Example 1)

The same procedure as in synthesizing Polyaniline conductive polymer composite 1 was conducted except for using only 225.0 mmol of (A-1) to give a conductive polymer composite.

### (Comparative Synthesis Examples 2 to 57)

The same procedure as in Comparative Synthesis Example 1 of polyaniline conductive polymer composite was conducted except for using the same amount of (A-2) or (A-3) as in Comparative Synthesis Example 1, together with Dopant polymers 2 to 19 in the same mole amounts to give conductive polymer composites.

### [Comparative Preparation Examples of Conductive Polymer Composite Composition containing Polyaniline-based Conductive Polymer]

As Comparative Preparation Examples 1 to 57, each of the green powder of the polyaniline-based conductive composites obtained in Comparative Synthesis Examples 1 to 57 was dispersed to ultrapure water in which acetylene glycol-base surfactant Surfynol 465 (manufactured by Nissin Chemical Industry Co., Ltd.) had been dissolved to have a concentration of 3.5 wt% to prepare Comparative Preparation liquids 1 to 57. As Comparative Preparation Examples 58 to 76, the component (C) amphoteric ion compound was added to Comparative Preparation liquids 1 to 19. Tables 11 and 12 show the composition and combination in Comparative Preparation Examples 1 to 76.

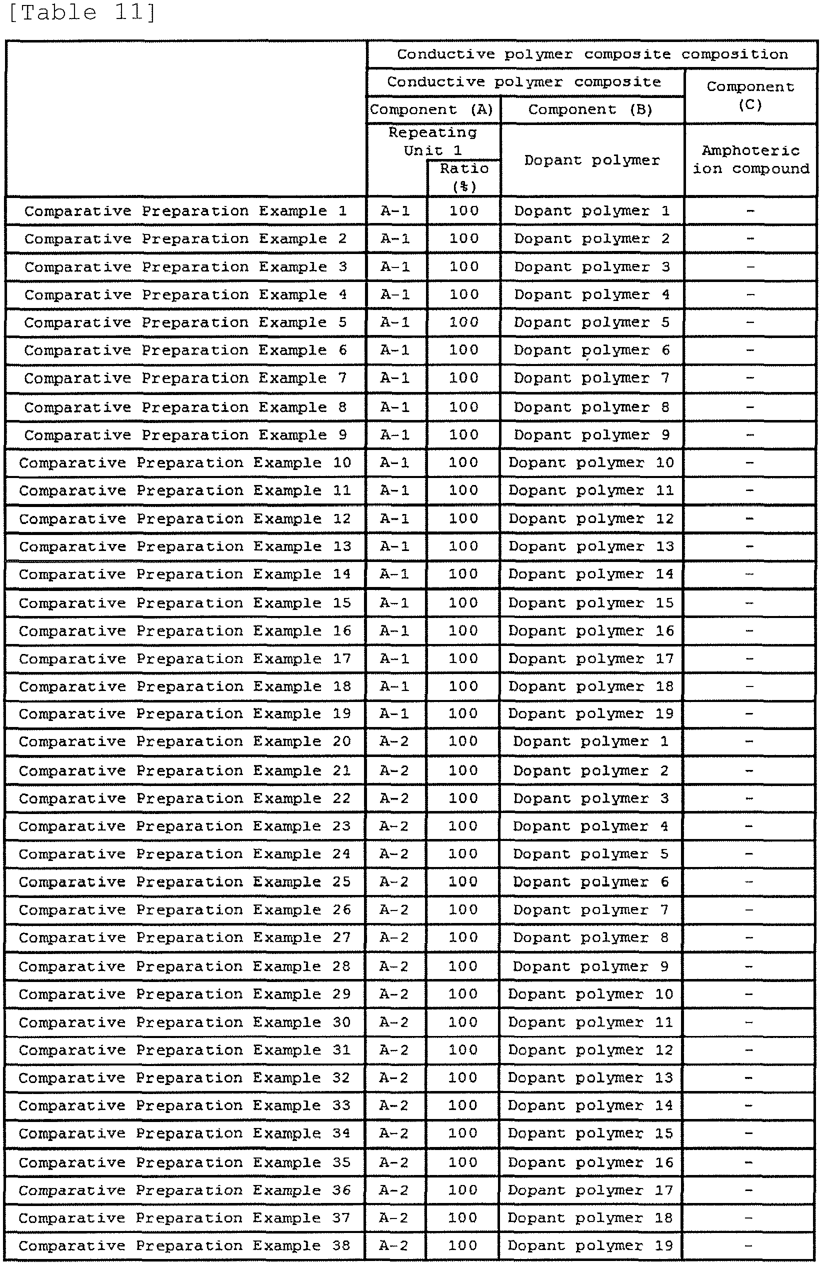

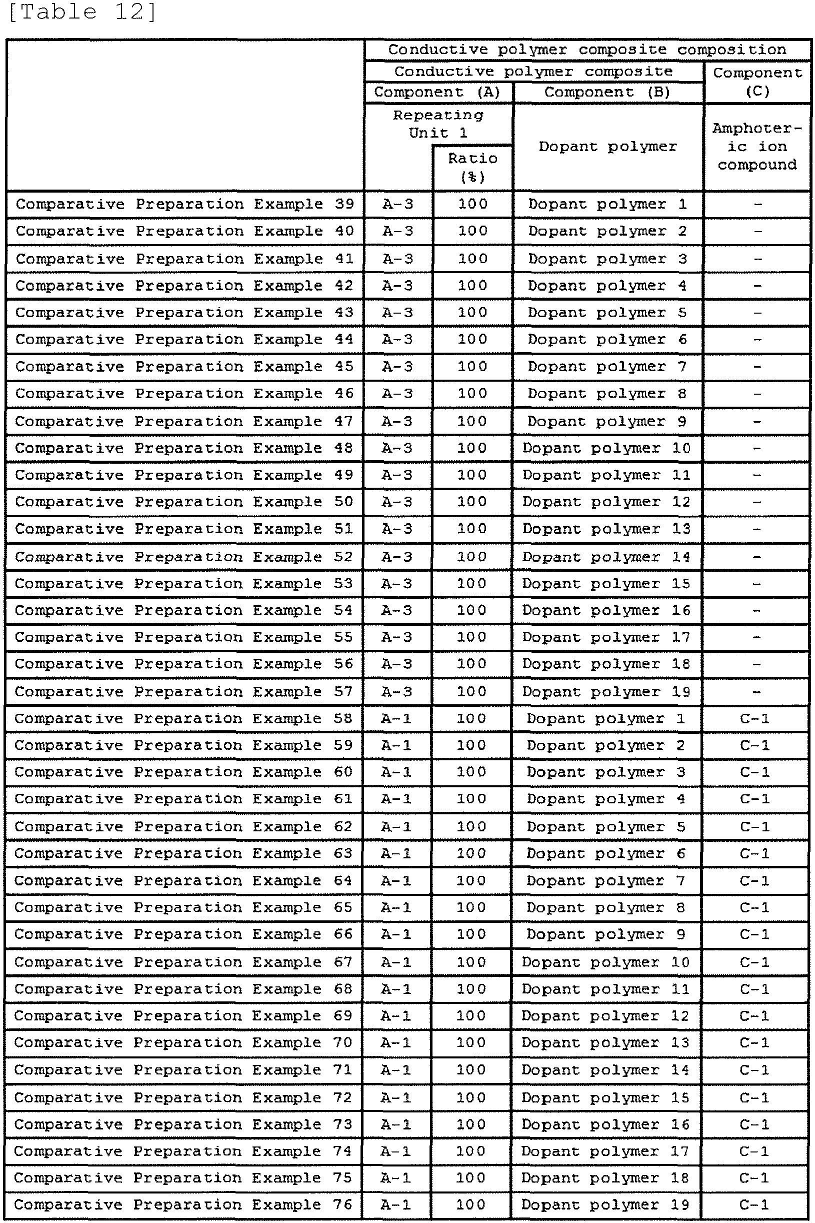

### [Examples]

The conductive polymer compositions prepared as described in Preparation Examples were evaluated as follows.

### (Filterability)

Each conductive polymer composition obtained in Preparation Examples was purified by pre-filtration using a regenerated cellulose filter having a pore diameter of 3.0 µm (manufactured by Advantec MFS, Inc.), and subsequently subjected to incremental filtration through a regenerated cellulose filter or a hydrophilic-treated UPE filter (manufactured by Entegris, Inc.) having a pore diameter of 1.0 to 0.02 µm, thereby examining a threshold pore diameter of the filter capable of passing liquid without clogging in this filtering step. The liquid-passing limits of the filter through which each of the conductive polymer compositions was filtrated in Preparation Examples 1 to 152 described above are shown in Tables 13 to 16.

### (Film formability)

Each conductive polymer composition obtained in Preparation Examples described above was applied by spin coating onto a Si wafer by using MS-A200 SPINCOATER (manufactured by MIKASA Co., Ltd.) so as to have a film thickness of 80±5 nm. Then, baking was performed for 5 minutes in an accuracy incubator at 120°C to remove the solvent, thereby the conductive film was obtained. If the uniform film could be formed, this is shown by "good", and if a defect derived from particles or a partial striation was found in the film, this is shown by "poor" in Tables 13 to 16.

### (Peelability by water washing)

Each conductive polymer composition obtained in Preparation Examples was applied to form an antistatic film by the same film-forming step as in the film formability (coatability) test. Onto this antistatic film, 5.0 ml of ultrapure water was spin coated to test the peelability. This was evaluated by the following standard: when the antistatic film was peeled uniformly with 5.0 ml of ultrapure water, it was evaluated as "good"; and when non-uniform peeling or flaky film-fall was formed, it was evaluated as "poor". The results are shown in Tables 13 to 16.

### (pH measurement)

The pH of the conductive polymer composition of Preparation Examples 1 to 152 was measured with a pH meter D-52 (manufactured by HORIBA Ltd.). The results are shown in Tables 13 to 16.

### (Surface resistivity)

Onto a SiO₂ wafer having a diameter of 4 inches (100 mm), 2.0 mL of each conductive polymer composition obtained in Preparation Examples 1 to 152 was dropped and spin coated on the whole thereof using MS-A200 SPINCOATER (manufactured by MIKASA Co., Ltd.). The spin coating conditions were adjusted so as to give a film thickness of 100±5 nm. Then, baking was performed for 5 minutes in an accuracy incubator at 120°C to remove the solvent, thereby the conductive film was obtained.

The surface resistivity (Ω/□) of the conductive film thus obtained was measured by Hiresta-UP MCP-HT450 and Loresta-GP MCP-T610 (both are manufactured by Mitsubishi Chemical corp.). The results are shown in Tables 13 to 16.

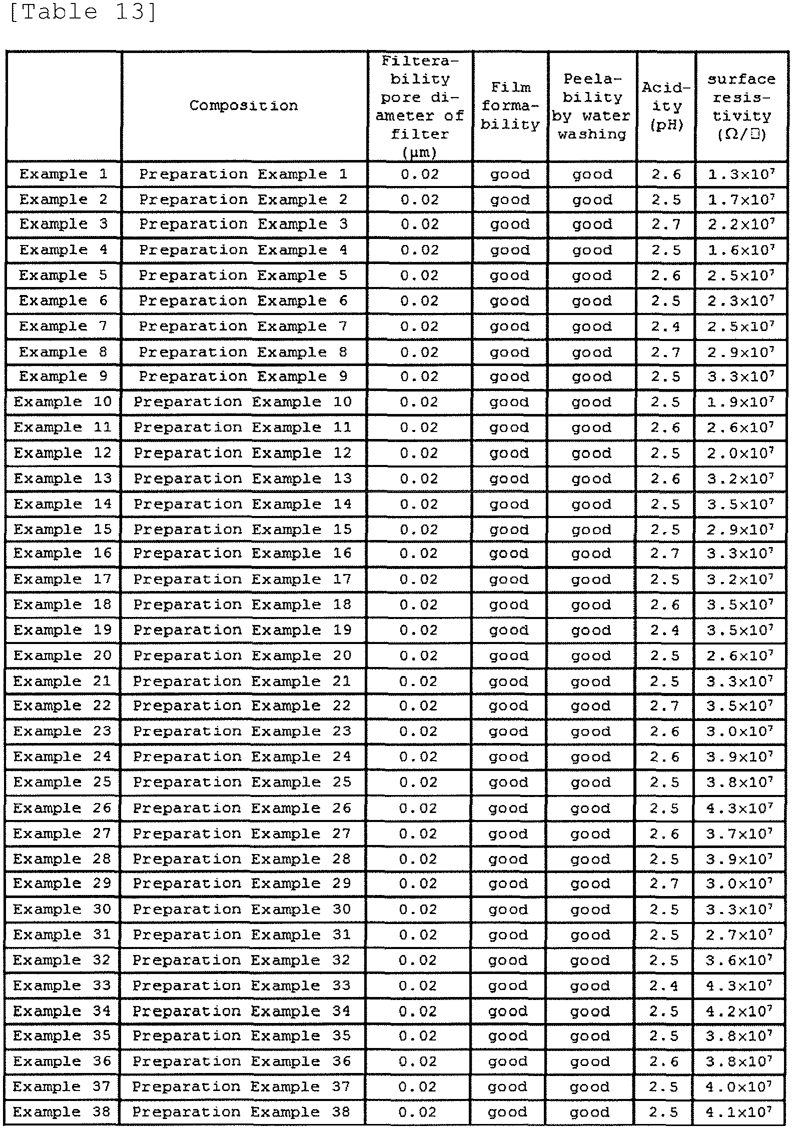

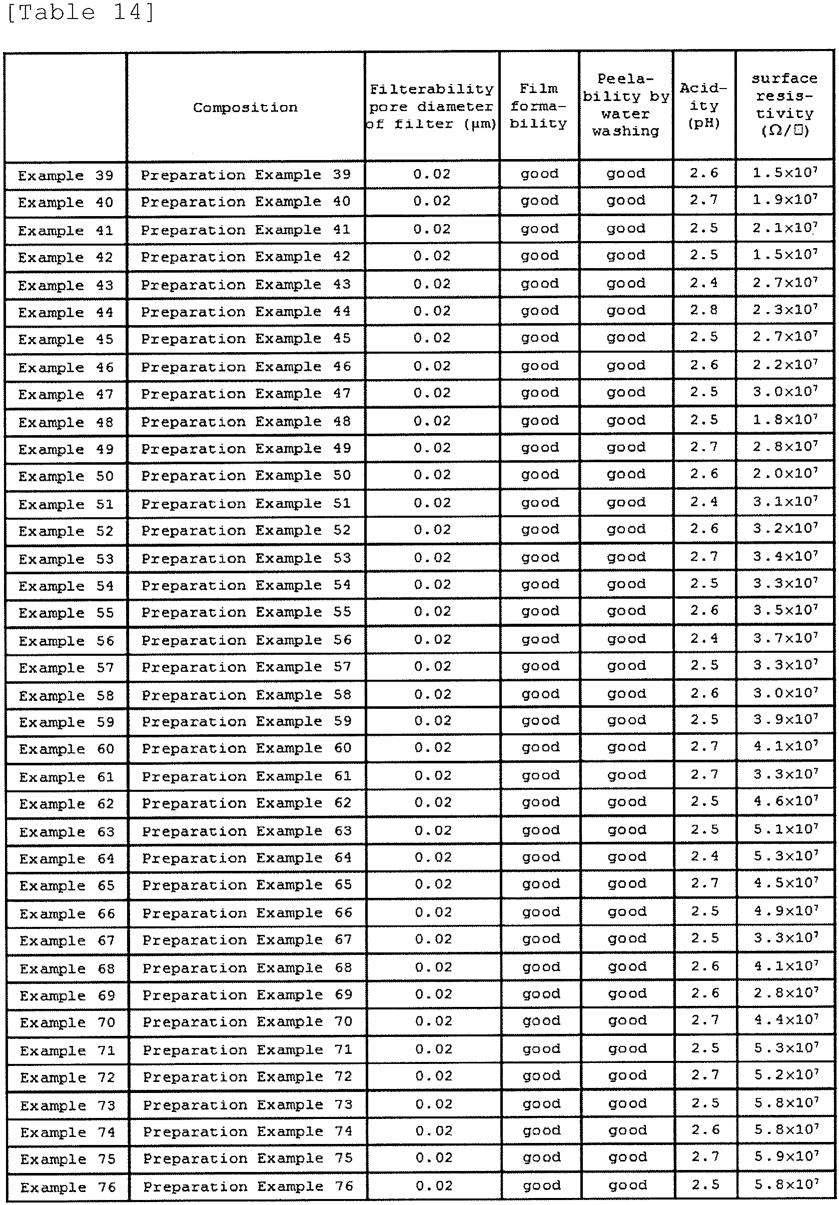

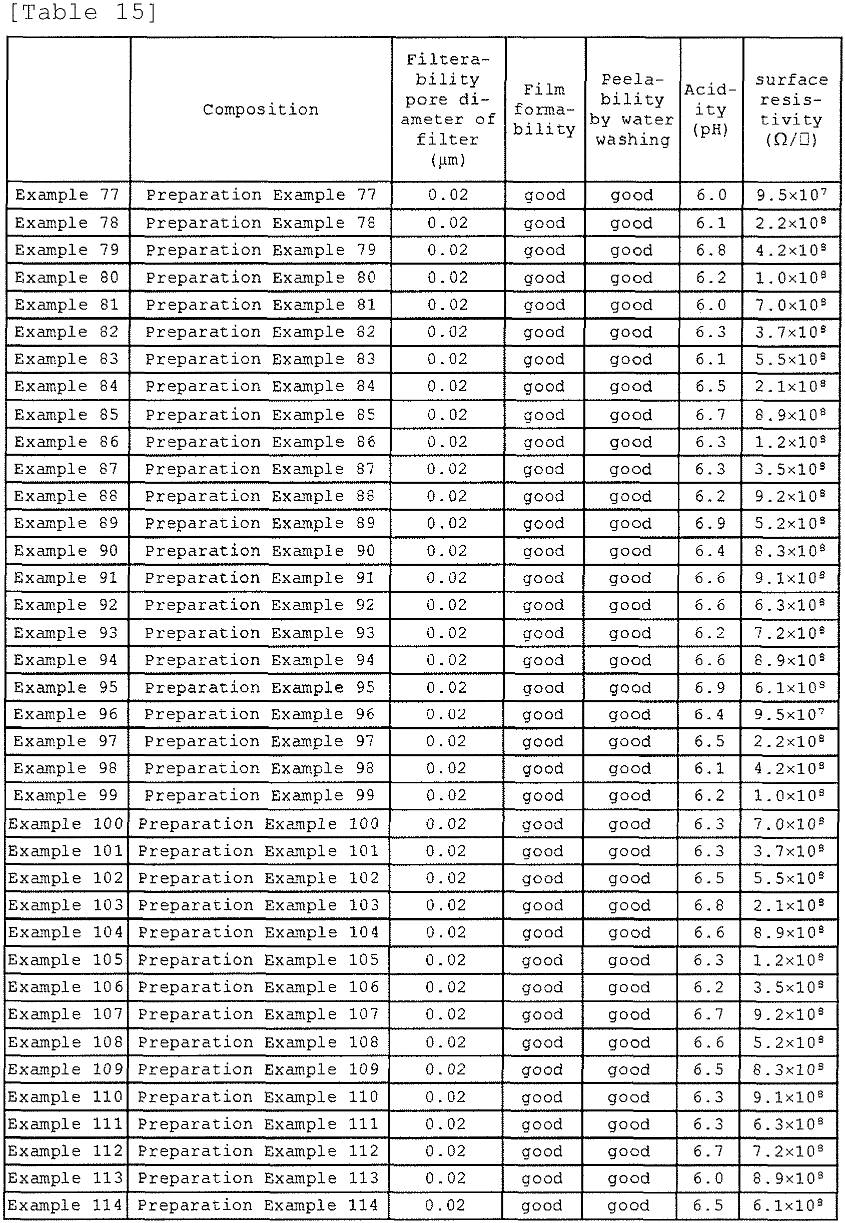

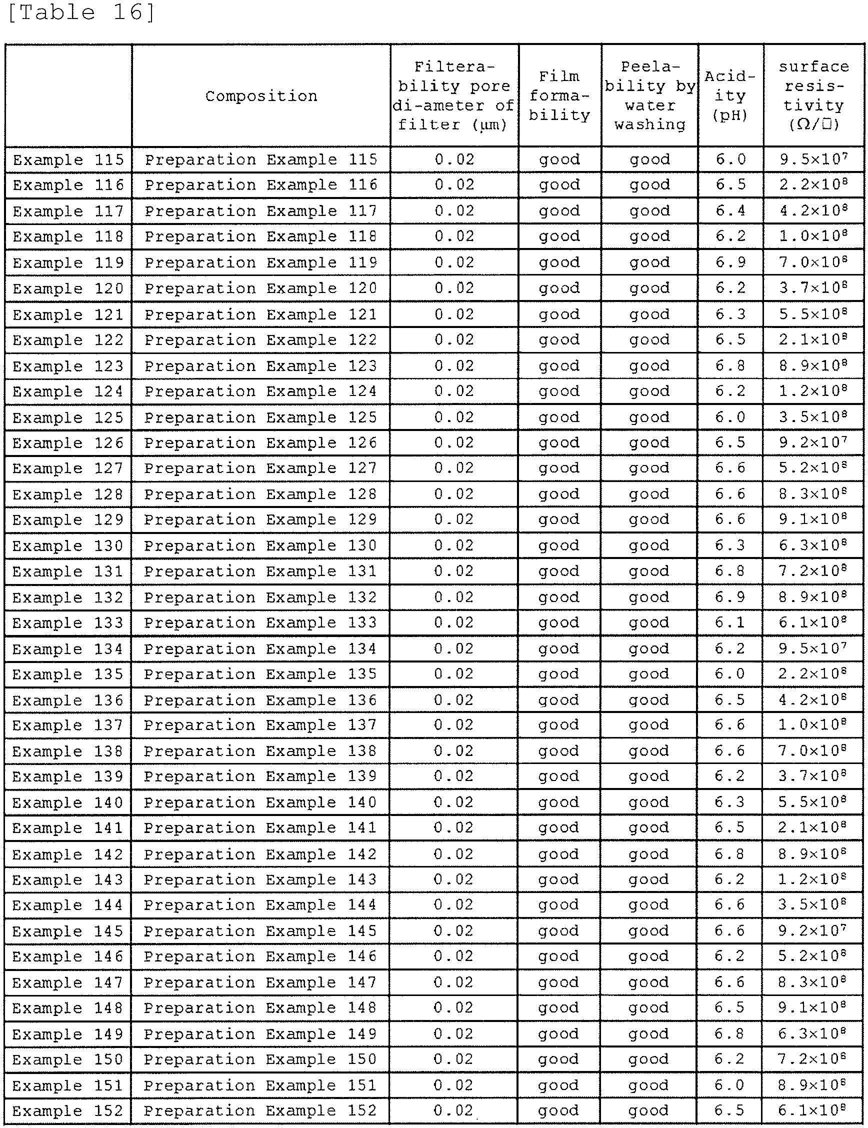

### [Comparative Examples]

The conductive polymer compositions prepared as described in Comparative Preparation Examples 1 to 76 were evaluated regarding filtrability, film formability, peelability by water washing, pH, and surface resistivity by the same way as in Preparation Examples shown in Examples. The evaluation results of each term are shown in Tables 17 and 18.

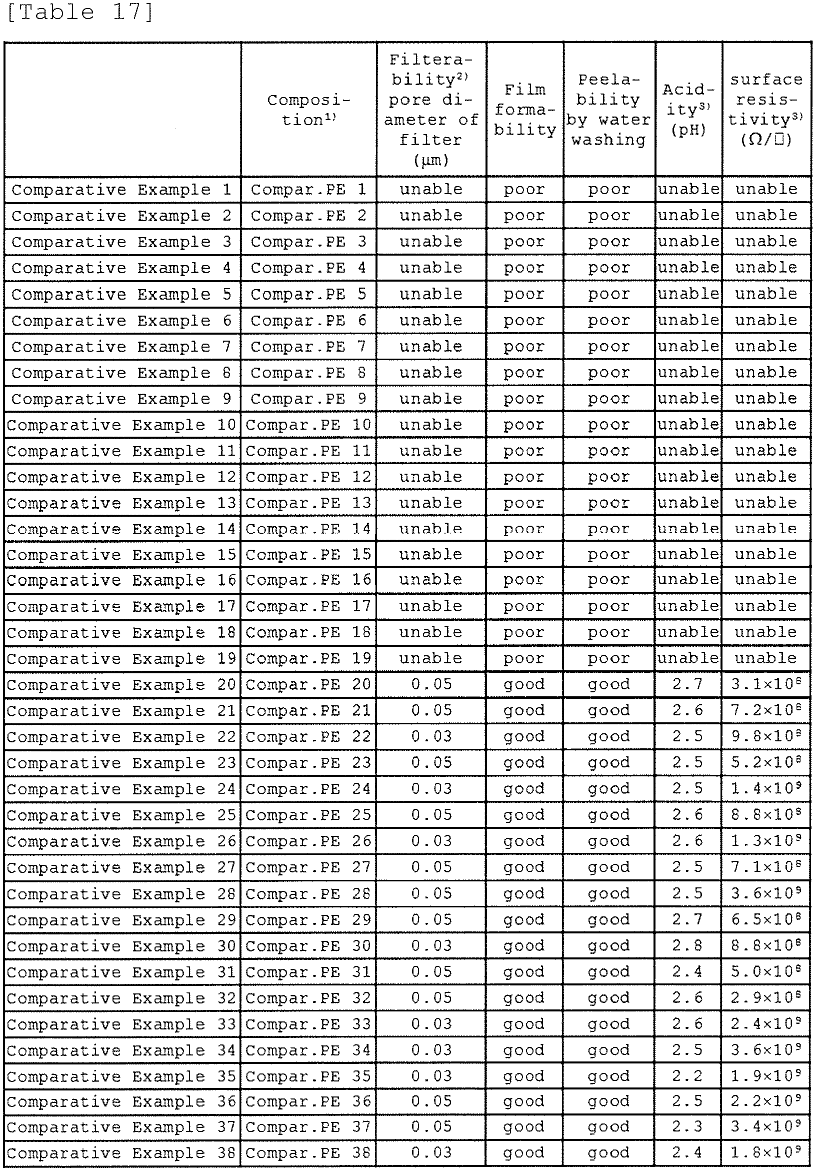

1) Compar.PE: Comparative Preparation Example 2) unable: unable to filter 3) unable: unable to measure

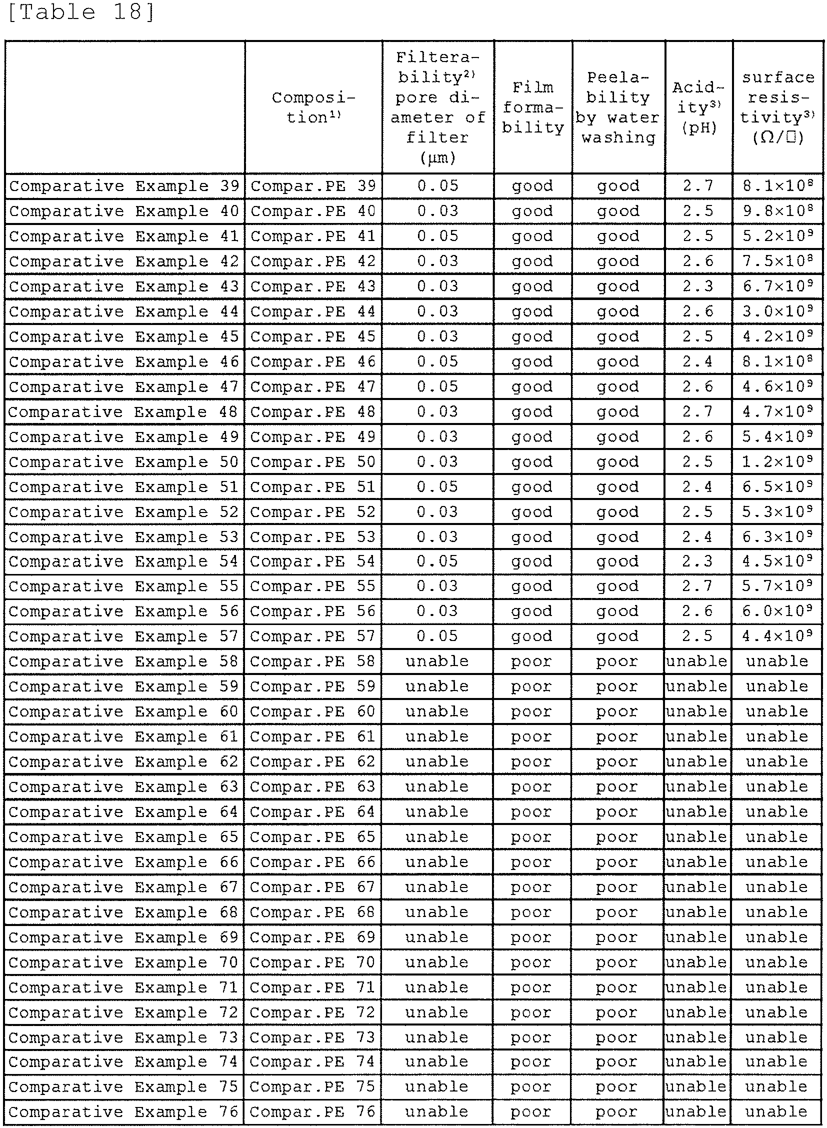

1) Compar.PE: Comparative Preparation Example
2) unable: unable to filter 3) unable: unable to measure

As shown in Tables 13 to 16, each of the conductive polymer composites of Synthesis Examples 1 to 76, in which a polyaniline-based conductive polymer has two kinds of anilines as the repeating units and the composite is formed with polyanion as a dopant, exhibited good filtrability and succeeded to give a uniform film by coating with a spin coater in the form of composition shown in Preparation Examples 1 to 152. Each coated film formed after heat drying exhibited lower surface resistivity.

On the other hand, in Comparative Examples 1 to 76 shown in Tables 17 and 18, each aniline-based conductive polymer had only one kind of aniline repeating unit. In this case, when the aniline repeating unit was A-1, the cohesiveness was strong, causing sedimentation or enormous increase of viscosity, and the filtration was impossible thereby. As a result, they could not form a film and were impossible to evaluate peelability by water washing, acidity, and surface resistivity. When the aniline repeating unit was A-2 or A-3, the filtration could be performed without causing sedimentation or enormous increase of viscosity as in the cased using only A-1. However, the liquid-passing limit of pore diameter was larger than the pore diameter of the composition in Preparation Examples 1 to 76 shown in Examples 1 to 76. Although the film formability, peelability by water washing, and acidity were equal to those of the composition in Preparation Examples 1 to 76 shown in Examples 1 to 76, the surface resistivity, which is an indication of antistatic performance in a step of electron beam drawing to an electron beam resist, was 10¹ to 10² times larger than those of the compositions of Preparation Examples 1 to 76. That is, the results showed lower ability to release the charge in a step of electron beam drawing.

In Preparation Examples shown in Examples 77 to 152 of Tables 15 and 16, having a composition in which (C) an amphoteric ion compound was added to the conductive polymer composition, the acidity was successfully adjusted to around neutrality without causing cohesion, degradation, or precipitation of solid of the aniline-based conductive polymer even after addition of the amphoteric ion compound. On the other hand, in Comparative Preparation Examples of conductive polymer composite shown in Comparative Examples 68 to 76 of Table 18, with the polymer having only one kind aniline as a repeating unit, the cohesion of conductive polymer composite due to neutralization could not be solved even after addition of the amphoteric ion compound. Accordingly, the filtration was impossible due to the sedimentation and higher viscosity, and it failed to form a film to evaluate peelability by water washing, acidity, and surface resistivity.

As described above, the inventive aniline-based conductive polymer composition, having two or more kinds of aniline repeating units, is capable of forming an antistatic film that effectively releases the charges generated in a step of electron beam drawing of electron beam resist, together with forming an antistatic film in which the acidity is modified by adding an amphoteric ion to minimize the influence of acid to a resist.

## Claims

1. A conductive polymer composition comprising:
(A) a polyaniline-based conductive polymer having two or more kinds of repeating units shown by the following general formula (1); and
(B) a dopant polymer which contains a repeating unit shown by the following general formula (2) and has a weight-average molecular weight in a range of 1,000 to 500,000;
wherein the weight-average molecular weight is a measured value in terms of polyethylene oxide, polyethylene glycol, or polystyrene by gel permeation chromatography using water, dimethylformamide, or tetrahydrofuran as a solvent, 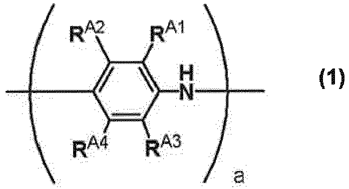 wherein R^{A1} to R^{A4} each independently represent any of a linear, branched, or cyclic monovalent hydrocarbon group having 1 to 20 carbon atoms and optionally containing a heteroatom, a hydrogen atom, and a halogen atom; R^{A1} and R^{A2} or R^{A3} and R^{A4} are optionally bonded to each other to form a ring; and "a" is a molar ratio satisfying 0 < a < 1.0; 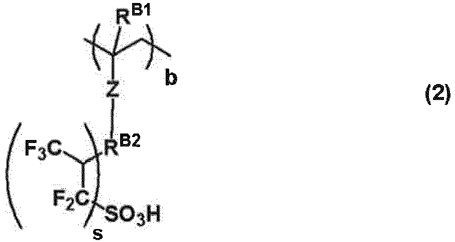 wherein R^{B1} represents a hydrogen atom or a methyl group; R^{B2} represents any of a single bond, an ester group, and a linear, branched, or cyclic hydrocarbon group having 1 to 12 carbon atoms and optionally containing either or both of an ether group and an ester group; "Z" represents any of a single bond, a phenylene group, a naphtylene group, and an ester group; "b" is a molar ratio satisfying 0 < b ≤ 1.0; and "s" is an integer of 1.

2. The conductive polymer composition according to claim 1, wherein, in the component (A), the repeating units of the component (A) contains a repeating unit-a1, in which all of R^{A1} to R^{A4} are hydrogen atoms, in a molar ratio of 50% < a1 < 100%.

3. The conductive polymer composition according to claim 1 or 2, wherein, in the component (A), the repeating units of the component (A) contains a repeating unit-a1, in which all of R^{A1} to R^{A4} are hydrogen atoms, in a molar ratio of 80% ≤ a1 < 100%.

4. The conductive polymer composition according to any one of claims 1 to 3, wherein the repeating unit-b in the component (B) contains at least one kind of repeating unit selected from the group consisting of repeating units b2 and b4 to b8 shown by the following general formulae (2-2) and (2-4) to (2-8); 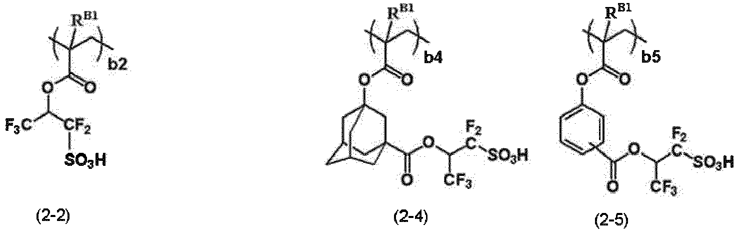 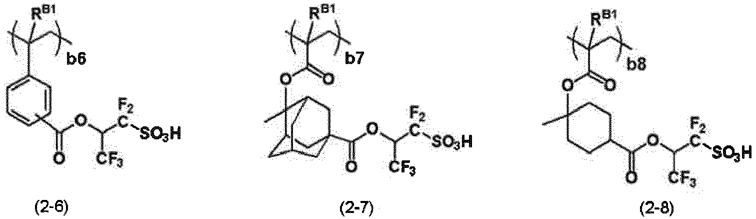 wherein R^{B1} has the same meaning as defined above, and b1, b2, b3, b4, b5, b6, b7, and b8 are molar ratios each satisfying 0 ≤ b1 ≤ 1.0, 0 ≤ b2 ≤ 1.0, 0 ≤ b3 ≤ 1.0, 0 ≤ b4 ≤ 1.0, 0 ≤ b5 ≤ 1.0, 0 ≤ b6 ≤ 1.0, 0 ≤ b7 ≤ 1.0, 0 ≤ b8 ≤ 1.0, and 0 < b1+b2+b3+b4+b5+b6+b7+b8 ≤ 1.0.

5. The conductive polymer composition according to any one of claims 1 to 4, further comprising (C) an amphoteric ion compound shown by the following general formula (3); 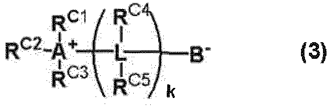 wherein R^{C1} to R^{C3} each independently represent a linear, branched, or cyclic monovalent hydrocarbon group having 1 to 20 carbon atoms and optionally substituted with or containing a heteroatom, or a hydrogen atom; R^{C1} and R^{C2}, or R^{C1}, R^{C2}, and R^{C3} are optionally bonded to each other to form a ring with A⁺ in the formula; A⁺ is a hetero atom and represents a monovalent cation; "k" is an integer of 1 to 8; L represents a carbon atom or a heteroatom, the both of which are optionally contained when "k" is 2 or more; R^{C4} and R^{C5} each represent a hydrogen atom, a hydroxy group, an amino group, or a linear, branched, or cyclic monovalent hydrocarbon group having 1 to 20 carbon atoms and optionally containing a heteroatom; R^{C4} and R^{C5} are optionally bonded to each other to form a ring, and adjoining R^{C4} are optionally bonded to each other to form a ring when "k" is 2 or more; R^{C4} and R^{C5} are optionally bonded to each other with an oxygen atom or a nitrogen atom to form a double bond, and when the double bond is formed with a nitrogen atom, the nitrogen atom is optionally an ion; L is optionally bonded with adjoining A⁺ to form a double bond, and adjoining L optionally form a double bond with each other when "k" is 2 or more; any of R^{C1} to R^{C3} are optionally bonded with R^{C4} or R^{C5} to form a ring; B⁻ is a monovalent anionic functional group and represents a carboxylate ion or a sulfonate ion.

6. The conductive polymer composition according to claim 5, wherein the component (C) is shown by the following general formula (4); 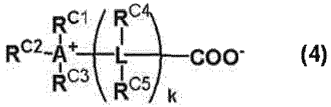 wherein R^{C1} to R^{C5}, A⁺, L, and "k" have the same meanings as defined above.

7. The conductive polymer composition according to claim 5 or 6, wherein the component (C) is in an amount of 1 to 70 parts by mass based on 100 parts by mass of a composite of the component (A) and the component (B).

8. The conductive polymer composition according to any one of claims 1 to 7, further comprising a nonionic surfactant.

9. The conductive polymer composition according to claim 8, wherein the nonionic surfactant is in an amount of 1 to 50 parts by mass based on 100 parts by mass of a composite of the component (A) and the component (B).

10. The conductive polymer composition according to any one of claims 1 to 9, wherein the conductive polymer composition is a material for forming a laminated film as a device constituent component in an organic thin-film device.

11. The conductive polymer composition according to claim 10, wherein the conductive polymer composition is a material for forming an electrode film or a material for forming a carrier transferring film.

12. A coated article, comprising a film formed from the conductive polymer composition according to any one of claims 1 to 11 on a body to be processed.

13. The coated article according to claim 12, wherein the body to be processed is a substrate having a chemically amplified resist film.

14. The coated article according to claim 13, wherein the body to be processed is a substrate for obtaining a resist pattern by pattern irradiation with electron beam.

15. A patterning process comprising the steps of:
forming an antistatic film on a chemically amplified resist film of a substrate having the chemically amplified resist film by using the conductive polymer composition according to any one of claims 1 to 9;
irradiating in a pattern with electron beam; and
developing with an alkaline developer to obtain a resist pattern.

## Patentansprüche

1. Leitfähige Polymerzusammensetzung, umfassend:
(A) ein leitfähiges Polymer auf Polyanilinbasis mit zwei oder mehr Arten von sich wiederholenden Einheiten, die durch die folgende allgemeine Formel (1) dargestellt sind; und
(B) ein Dotierungspolymer, das eine durch die folgende allgemeine Formel (2) dargestellte sich wiederholende Einheit enthält und ein gewichtsmittleres Molekulargewicht im Bereich von 1.000 bis 500.000 aufweist;
wobei das gewichtsmittlere Molekulargewicht ein durch Gelpermeationschromatographie unter Verwendung von Wasser, Dimethylformamid oder Tetrahydrofuran als Lösungsmittel gemessener Wert in Form von Polyethylenoxid, Polyethylenglykol oder Polystyrol ist, 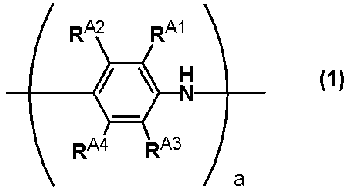 worin R^{A1} bis R^{A4} jeweils unabhängig voneinander eine lineare, verzweigte oder cyclische einwertige Kohlenwasserstoffgruppe mit 1 bis 20 Kohlenstoffatomen darstellen und gegebenenfalls ein Heteroatom, ein Wasserstoffatom und ein Halogenatom enthalten; R^{A1} und R^{A2} oder R^{A3} und R^{A4} gegebenenfalls unter Bildung eines Rings aneinander gebunden sind; und "a" ein Molverhältnis ist, das 0 < a < 1,0 genügt; 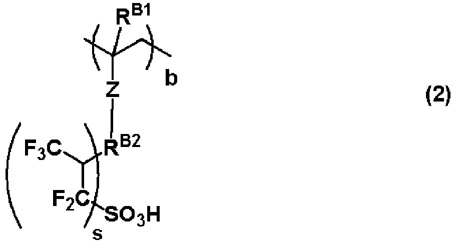 worin R^{B1} ein Wasserstoffatom oder eine Methylgruppe darstellt; R^{B2} eine Einfachbindung, eine Estergruppe oder eine lineare, verzweigte oder zyklische Kohlenwasserstoffgruppe mit 1 bis 12 Kohlenstoffatomen darstellt, die gegebenenfalls entweder eine Ethergruppe oder eine Estergruppe oder beides enthält; "Z" eine Einfachbindung, eine Phenylengruppe, eine Naphthylengruppe oder eine Estergruppe darstellt; "b" ein Molverhältnis ist, das 0 < b ≤ 1,0 genügt; und "s" eine ganze Zahl von 1 ist.

2. Leitfähige Polymerzusammensetzung nach Anspruch 1, wobei in der Komponente (A) die sich wiederholenden Einheiten der Komponente (A) eine sich wiederholende Einheit-al, in der alle R^{A1} bis R^{A4} Wasserstoffatome sind, in einem Molverhältnis von 50% < a1 < 100% enthalten.

3. Leitfähige Polymerzusammensetzung nach Anspruch 1 oder 2, wobei in der Komponente (A) die sich wiederholenden Einheiten der Komponente (A) eine sich wiederholende Einheit-al, in der alle R^{A1} bis R^{A4} Wasserstoffatome sind, in einem molaren Verhältnis von 80% ≤ a1 < 100% enthalten.

4. Leitfähige Polymerzusammensetzung nach einem der Ansprüche 1 bis 3, wobei die sich wiederholende Einheit-b in der Komponente (B) mindestens eine Art von sich wiederholender Einheit enthält, die aus der Gruppe ausgewählt ist, die aus sich wiederholenden Einheiten b2 und b4 bis b8 besteht, die durch die folgenden allgemeinen Formeln (2-2) und (2-4) bis (2-8) dargestellt sind; 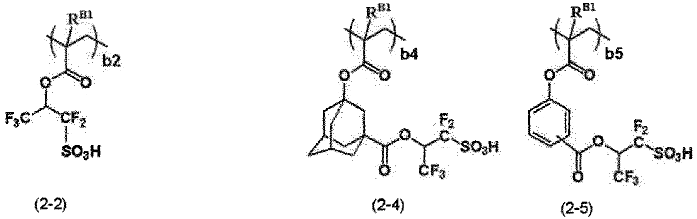 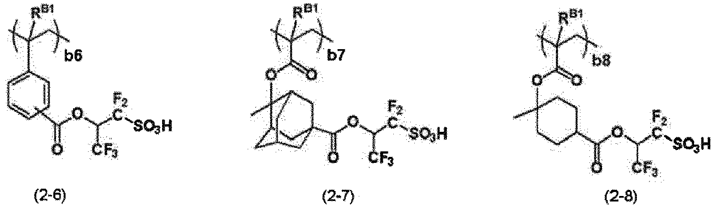 wobei R^{B1} die gleiche Bedeutung wie oben hat und b1, b2, b3, b4, b5, b6, b7 und b8 Molverhältnisse sind, die jeweils die Bedingungen 0 ≤ b1 ≤ 1,0, 0 ≤ b2 ≤ 1.0, 0 ≤ b3 ≤ 1,0, 0 ≤ b4 ≤ 1,0, 0 ≤ b5 ≤ 1,0, 0 ≤ b6 ≤ 1,0, 0 ≤ b7 ≤ 1,0, 0 ≤ b8 ≤ 1,0, und 0 < b1+b2+b3+b4+b5+b6+b7+b8 ≤ 1,0 erfüllen.

5. Leitfähige Polymerzusammensetzung nach einem der Ansprüche 1 bis 4, die ferner (C) eine amphotere Ionenverbindung der folgenden allgemeinen Formel (3) umfasst; 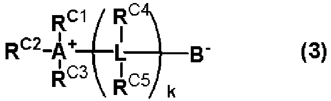 worin R^{C1} bis R^{C3} jeweils unabhängig voneinander eine lineare, verzweigte oder cyclische einwertige Kohlenwasserstoffgruppe mit 1 bis 20 Kohlenstoffatomen darstellen, die gegebenenfalls mit einem Heteroatom oder einem Wasserstoffatom substituiert ist oder ein Heteroatom enthält; R^{C1} und R^{C2} oder R^{C1}, R^{C2} und R^{C3} gegebenenfalls aneinander gebunden sind, um einen Ring mit A+ in der Formel zu bilden; A+ ein Heteroatom ist und ein einwertiges Kation darstellt; "k" ist eine ganze Zahl von 1 bis 8; L stellt ein Kohlenstoffatom oder ein Heteroatom dar, die beide gegebenenfalls enthalten sind, wenn "k" 2 oder mehr ist; R^{C4} und R^{C5} stellen jeweils ein Wasserstoffatom, eine Hydroxygruppe, eine Aminogruppe oder eine lineare, verzweigte oder cyclische einwertige Kohlenwasserstoffgruppe mit 1 bis 20 Kohlenstoffatomen dar, die gegebenenfalls ein Heteroatom enthält; R^{C4} und R^{C5} sind gegebenenfalls aneinander gebunden, um einen Ring zu bilden, und benachbarte R^{C4} sind gegebenenfalls aneinander gebunden, um einen Ring zu bilden, wenn "k" 2 oder mehr ist; R^{C4} und R^{C5} sind gegebenenfalls aneinander mit einem Sauerstoffatom oder einem Stickstoffatom gebunden, um eine Doppelbindung zu bilden, und wenn die Doppelbindung mit einem Stickstoffatom gebildet wird, ist das Stickstoffatom gegebenenfalls ein Ion; L ist gegebenenfalls mit dem benachbarten A+ verbunden, um eine Doppelbindung zu bilden, und benachbarte L bilden gegebenenfalls miteinander eine Doppelbindung, wenn "k" 2 oder mehr ist; R^{C1} bis R^{C3} sind gegebenenfalls mit R^{C4} oder R^{C5} verbunden, um einen Ring zu bilden; B- ist eine einwertige anionische funktionelle Gruppe und stellt ein Carboxylat-Ion oder ein Sulfonat-Ion dar.

6. Leitfähige Polymerzusammensetzung nach Anspruch 5, wobei die Komponente (C) durch die folgende allgemeine Formel (4) dargestellt wird; 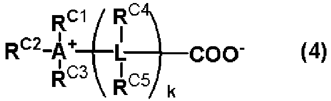 wobei R^{C1} bis R^{C5}, A+, L und "k" die gleichen Bedeutungen haben wie oben definiert.

7. Leitfähige Polymerzusammensetzung nach Anspruch 5 oder 6, wobei die Komponente (C) in einer Menge von 1 bis 70 Masseteilen, bezogen auf 100 Masseteile eines Verbunds aus der Komponente (A) und der Komponente (B), vorliegt.

8. Leitfähige Polymerzusammensetzung nach einem der Ansprüche 1 bis 7, die ferner ein nichtionisches Tensid enthält.

9. Leitfähige Polymerzusammensetzung nach Anspruch 8, wobei das nichtionische Tensid in einer Menge von 1 bis 50 Masseteilen, bezogen auf 100 Masseteile eines Komposits aus der Komponente (A) und der Komponente (B), vorliegt.

10. Leitfähige Polymerzusammensetzung nach einem der Ansprüche 1 bis 9, wobei es sich bei der leitfähigen Polymerzusammensetzung um ein Material zur Bildung eines laminierten Films als Vorrichtungsbestandteil in einer organischen Dünnschichtvorrichtung handelt.

11. Leitfähige Polymerzusammensetzung nach Anspruch 10, wobei die leitfähige Polymerzusammensetzung ein Material zur Bildung eines Elektrodenfilms oder ein Material zur Bildung eines Trägerübertragungsfilms ist.

12. Beschichteter Gegenstand, umfassend einen aus der leitfähigen Polymerzusammensetzung nach einem der Ansprüche 1 bis 11 gebildeten Film auf einem zu verarbeitenden Körper.

13. Beschichteter Gegenstand nach Anspruch 12, wobei der zu bearbeitende Körper ein Substrat mit einer chemisch verstärkten Resistschicht ist.

14. Beschichteter Gegenstand nach Anspruch 13, wobei der zu bearbeitende Körper ein Substrat zur Herstellung eines Resistmusters durch Bestrahlung mit einem Elektronenstrahl ist.

15. Strukturierungsverfahren, das die folgenden Schritte umfasst:
Bilden eines antistatischen Films auf einem chemisch verstärkten Resistfilm eines Substrats mit dem chemisch verstärkten Resistfilm unter Verwendung der leitfähigen Polymerzusammensetzung nach einem der Ansprüche 1 bis 9;
Bestrahlung in einem Muster mit einem Elektronenstrahl; und
Entwickeln mit einem alkalischen Entwickler, um ein Resistmuster zu erhalten.

## Revendications

1. Composition polymère conductrice comprenant :
(A) un polymère conducteur à base de polyaniline ayant au moins deux types de motifs de répétition représentés par la formule générale (1) suivante ; et
(B) un polymère dopant qui contient un motif de répétition représenté par la formule générale (2) suivante et a un poids moléculaire moyen en poids dans une plage de 1 000 à 500 000 ;
dans lequel le poids moléculaire moyen en poids est une valeur mesurée en termes d'oxyde de polyéthylène, de polyéthylène glycol ou de polystyrène par chromatographie sur gel en utilisant de l'eau, du diméthylformamide ou du tétrahydrofurane comme solvant, 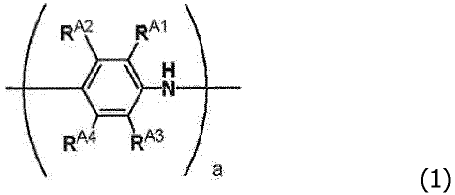 dans laquelle R^{A1} à R^{A4} représentent chacun indépendamment l'un quelconque d'un groupe hydrocarboné monovalent linéaire, ramifié ou cyclique ayant 1 à 20 atomes de carbone et contenant éventuellement un hétéroatome, un atome d'hydrogène et un atome d'halogène ; R^{A1} et R^{A2} ou R^{A3} et R^{A4} sont éventuellement liés l'un à l'autre pour former un cycle ; et « a » est un rapport molaire satisfaisant 0 < a < 1,0 ; 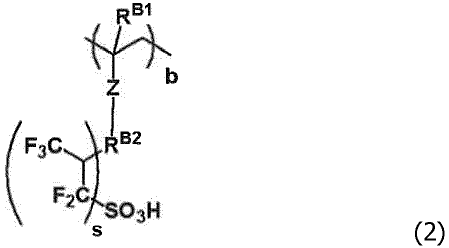 dans laquelle R^{B1} représente un atome d'hydrogène ou un groupe méthyle ; R^{B2} représente l'un quelconque d'une liaison simple, d'un groupe ester et d'un groupe hydrocarboné linéaire, ramifié ou cyclique ayant 1 à 12 atomes de carbone et contenant éventuellement l'un ou les deux d'un groupe éther et d'un groupe ester ; « Z » représente l'une quelconque d'une liaison simple, d'un groupe phénylène, d'un groupe naphtylène et d'un groupe ester ; « b » est un rapport molaire satisfaisant 0 < b ≤ 1,0 ; et « s » est un nombre entier de 1.

2. Composition polymère conductrice selon la revendication 1, dans laquelle, dans le composant (A), les motifs de répétition du composant (A) contiennent un motif de répétition a1, dans lequel l'ensemble des R^{A1} à R^{A4} sont des atomes d'hydrogène, selon un rapport molaire de 50 % < a1 < 100 %.

3. Composition polymère conductrice selon la revendication 1 ou 2, dans laquelle, dans le composant (A), les motifs de répétition du composant (A) contiennent un motif de répétition a1, dans lequel l'ensemble des R^{A1} à R^{A4} sont des atomes d'hydrogène, selon un rapport molaire de 80 % ≤ a1 < 100 %.

4. Composition polymère conductrice selon l'une quelconque des revendications 1 à 3, dans laquelle le motif de répétition b dans le composant (B) contient au moins un type de motif de répétition choisi dans le groupe constitué par les motifs de répétition b2 et b4 à b8 représentés par les formules générales (2-2) et (2-4) à (2-8) suivantes ; 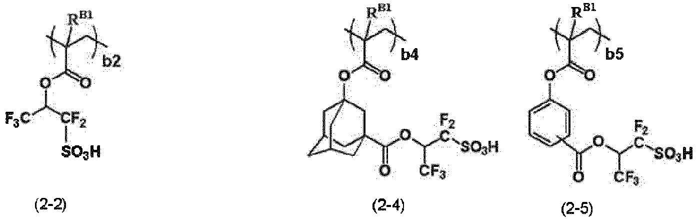 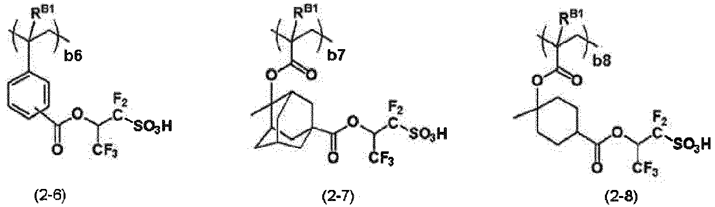 dans lesquelles R^{B1} a la même signification que celle définie ci-dessus, et b1, b2, b3, b4, b5, b6, b7 et b8 sont des rapports molaires satisfaisant chacun 0 ≤ b1 ≤ 1,0, 0 ≤ b2 ≤ 1,0, 0 ≤ b3 ≤ 1,0, 0 ≤ b4 ≤ 1,0, 0 ≤ b5 ≤ 1,0, 0 ≤ b6 ≤ 1,0, 0 ≤ b7 ≤ 1,0, 0 ≤ b8 ≤ 1,0, et 0 < b1+b2+b3+b4+b5+b6+b7+b8 ≤ 1,0.

5. Composition polymère conductrice selon l'une quelconque des revendications 1 à 4, comprenant en outre (C) un composé ionique amphotère représenté par la formule générale (3) suivante ; 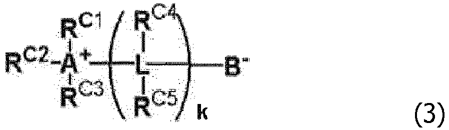 dans laquelle R^{C1} à R^{C3} représentent chacun indépendamment un groupe hydrocarboné monovalent linéaire, ramifié ou cyclique ayant 1 à 20 atomes de carbone et éventuellement substitué par ou contenant un hétéroatome, ou un atome d'hydrogène ; R^{C1} et R^{C2}, ou R^{C1}, R^{C2} et R^{C3} sont éventuellement liés l'un à l'autre pour former un cycle avec A⁺ dans la formule ; A⁺ est un hétéroatome et représente un cation monovalent ; « k » est un nombre entier de 1 à 8 ; L représente un atome de carbone ou un hétéroatome, les deux étant éventuellement contenus lorsque « k » est 2 ou plus ; R^{C4} et R^{C5} représentent chacun un atome d'hydrogène, un groupe hydroxy, un groupe amino ou un groupe hydrocarboné monovalent linéaire, ramifié ou cyclique ayant 1 à 20 atomes de carbone et contenant éventuellement un hétéroatome ; R^{C4} et R^{C5} sont éventuellement liés l'un à l'autre pour former un cycle, et des R^{C4} adjacents sont éventuellement liés les uns aux autres pour former un cycle lorsque « k » est 2 ou plus ; R^{C4} et R^{C5} sont éventuellement liés l'un à l'autre avec un atome d'oxygène ou un atome d'azote pour former une double liaison, et lorsque la double liaison est formée avec un atome d'azote, l'atome d'azote est éventuellement un ion ; L est éventuellement lié avec un A⁺ adjacent pour former une double liaison, et des L adjacents forment éventuellement une double liaison l'un avec l'autre lorsque « k » est 2 ou plus ; l'un quelconque de R^{C1} à R^{C3} est éventuellement lié à R^{C4} ou R^{C5} pour former un cycle ; B⁻ est un groupe fonctionnel anionique monovalent et représente un ion carboxylate ou un ion sulfonate.

6. Composition polymère conductrice selon la revendication 5, dans laquelle le composant (C) est représenté par la formule générale (4) suivante ; 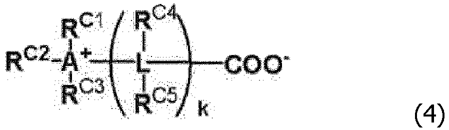 dans laquelle R^{C1} à R^{C5}, A⁺, L et « k » ont les mêmes significations que celles définies ci-dessus.

7. Composition polymère conductrice selon la revendication 5 ou 6, dans laquelle le composant (C) est en une quantité de 1 à 70 parties en masse par rapport à 100 parties en masse d'un composite du composant (A) et du composant (B).

8. Composition polymère conductrice selon l'une quelconque des revendications 1 à 7, comprenant en outre un tensioactif non ionique.

9. Composition polymère conductrice selon la revendication 8, dans laquelle le tensioactif non ionique est en une quantité de 1 à 50 parties en masse par rapport à 100 parties en masse d'un composite du composant (A) et du composant (B).

10. Composition polymère conductrice selon l'une quelconque des revendications 1 à 9, dans laquelle la composition polymère conductrice est un matériau pour former un film stratifié en tant que composant constitutif de dispositif dans un dispositif à film mince organique.

11. Composition polymère conductrice selon la revendication 10, dans laquelle la composition polymère conductrice est un matériau pour former un film d'électrode ou un matériau pour former un film de transfert de support.

12. Article revêtu, comprenant un film formé à partir de la composition polymère conductrice selon l'une quelconque des revendications 1 à 11 sur un corps à traiter.

13. Article revêtu selon la revendication 12, dans lequel le corps à traiter est un substrat ayant un film de réserve chimiquement amplifié.

14. Article revêtu selon la revendication 13, dans lequel le corps à traiter est un substrat pour obtenir un motif de réserve par irradiation selon un motif avec un faisceau d'électrons.

15. Procédé de formation de motif comprenant les étapes de :
formation d'un film antistatique sur un film de réserve chimiquement amplifié d'un substrat ayant le film de réserve chimiquement amplifié en utilisant la composition polymère conductrice selon l'une quelconque des revendications 1 à 9 ;
irradiation selon un motif avec un faisceau d'électrons ; et
développement avec un révélateur alcalin pour obtenir un motif de réserve.
